# EUROPEAN PATENT APPLICATION

(11) **EP 2 549 586 A1**
(43) Date of publication of application: **23.01.2013**
(21) Application number: 11755815.5
(22) Date of filing: 18.02.2011
(51) Int. Cl.: H01Q 1/52, H01Q 1/24, H04M 1/02, H05K 1/02

(54) **ELECTRONIC APPARATUS**

(30) Priority: 19.03.2010 JP 2010064759
(71) Applicant: NEC Corporation, Tokyo 108-8001 (JP)
(72) Inventor: TSUTSUMI, Goichi, Tokyo 108-8001 (JP); KOBAYASHI, Naoki, Tokyo 108-8001 (JP); ANDO, Noriaki, Tokyo 108-8001 (JP); TOYAO, Hiroshi, Tokyo 108-8001 (JP); IMAZATO, Masaharu, Tokyo 108-8001 (JP)
(74) Representative: Vossius & Partner
(86) International application number: PCT/JP2011/000904
(87) International publication number: WO 2011/114622

(57) **Abstract**

An electronic apparatus is provided which includes a first housing that is provided with a first electronic component (11), a second housing that is provided with a second electronic component (21), an antenna which is provided at an end portion of the first housing, and a connection body (40) which passes through the end portion of the first housing and connects the first electronic component (11) and the second electronic component (21) to each other, wherein the connection body (40) has an electric conductor layer, a dielectric layer, and a first conductor having a repeated structure at least in some areas. According to the electronic apparatus, a disadvantage can be suppressed in which in a case where a flexible substrate is disposed in the vicinity of the antenna, antenna characteristics deteriorate due to the flexible substrate.

## Description

### TECHNICAL FIELD

The present invention relates to an electronic apparatus.

### BACKGROUND ART

There is an electronic apparatus which includes a first housing that is provided with a first electronic component, a second housing that is provided with a second electronic component, a flexible substrate that electrically connects the first electronic component and the second electronic component to each other, and an antenna. For example, a so-called folding type mobile phone, a sliding type mobile phone, or the like corresponds thereto.

In the electronic apparatus as described above, because of the restriction of the size of the electronic apparatus or an antenna disposition position, or the like, there is a case where the flexible substrate that electrically connects the first electronic component and the second electronic component to each other and the antenna are disposed close to each other. For example, in the case of the folding type mobile phone, there is a case where the antenna and the flexible substrate which electrically connects the first electronic component and the second electronic component to each other are disposed in the vicinity of a hinge which connects the first housing (for example, a housing having operation buttons or the like) and the second housing (for example, a housing having a display or the like) to each other, and a state is created where these elements are close to each other.

In a case where the flexible substrate is disposed in the vicinity of the antenna in this manner, radio waves transmitted from the antenna interfere with a conductor other than the antenna, thereby generating an electric current, or current noise flowing through a conductor of the flexible substrate affects the antenna, whereby there is a concern that antenna characteristics may deteriorate.

Here, as means for solving the deterioration of antenna characteristics, there is a technique described in Patent Document 1. A portable radio communication apparatus described in Patent Document 1 includes a first transmitting and receiving section which performs the transmission and reception of an RF signal, an antenna provided at the first transmitting and receiving section, a second transmitting and receiving section which is provided away from the first transmitting and receiving section and performs the transmission and reception of a base band signal, and a connecting wire which connects the first transmitting and receiving section and the second transmitting and receiving section to each other, wherein an inductance element having an appropriate inductance value is further provided on the route of the connecting wire, thereby shutting off a high frequency which flows from the first transmitting and receiving section to the second transmitting and receiving section and suppressing the deterioration of antenna characteristics.

### RELATED DOCUMENT

### PATENT DOCUMENT

[Patent Document 1] Japanese Patent No. 2989850

### DISCLOSURE OF THE INVENTION

However, in the case of the technique described in Patent Document 1, radio waves transmitted from the antenna interfering with the conductor of the flexible substrate, thereby generating an electric current, cannot be suppressed.

Therefore, in the present invention, in an electronic apparatus in which a flexible substrate is sometimes disposed in the vicinity of an antenna, means for suppressing deterioration of antenna characteristics due to the flexible substrate is provided.

According to an aspect of the invention, there is provided an electronic apparatus which includes a first housing that is provided with a first electronic component, a second housing that is provided with a second electronic component, an antenna that is provided at an end portion of the first housing, and a connection body which passes through the end portion of the first housing and connects the first electronic component and the second electronic component to each other, wherein the connection body has an electric conductor layer, a dielectric layer, and a first conductor having a repeated structure at least in some areas.

According to the invention, in an electronic apparatus in which a flexible substrate is sometimes disposed in the vicinity of an antenna, deterioration of antenna characteristics due to the flexible substrate can be suppressed.

### BRIEF DESCRIPTION OF THE DRAWINGS

FIG. 1 is a perspective view schematically showing an example of an electronic apparatus related to an embodiment.
Fig. 2 is a perspective view schematically showing an example of the internal structure of the electronic apparatus related to the embodiment.
Fig. 3 is a plan view and side view schematically showing an example of the internal structure of the electronic apparatus related to the embodiment.
Fig. 4 is a perspective view schematically showing an example of the internal structure of the electronic apparatus related to the embodiment.
Fig. 5 is a diagram schematically showing an example of the cross-sectional structure of a connection body in the embodiment.
Fig. 6 is a diagram schematically showing the cross-sectional structure of the outermost layer of a first structure body and a second structure body in the embodiment.
Fig. 7 is a perspective view schematically showing an example of an EBG structure which is constituted in the connection body in the embodiment.
Fig. 8 is a cross-sectional view schematically showing an example of the EBG structure which is constituted in the connection body in the embodiment.
Fig. 9 is an equivalent circuit diagram of a unit cell of the EBG structure which is constituted in the connection body in the embodiment.
Fig. 10 is an equivalent circuit diagram of the EBG structure which is constituted in the connection body in the embodiment.
Fig. 11 is an expression calculating a frequency band of noise, propagation of which is suppressed by the EBG structure.
Fig. 12 is a diagram showing the interaction between an antenna and the connection body.
Fig. 13 is a diagram for describing an example of a position where the second structure body in the embodiment is provided.
Fig. 14 is a diagram for describing a method of manufacturing the second structure body in the embodiment.
Fig. 15 is a diagram schematically showing the cross-sectional structure of the outermost layer of the first structure body and the second structure body in the embodiment.
Fig. 16 is a diagram schematically showing the cross-sectional structure of the outermost layer of the first structure body and the second structure body in the embodiment.
Fig. 17 is a plan view schematically showing the outermost layer of the first structure body and the second structure body in the embodiment.
Fig. 18 is an equivalent circuit diagram of a unit cell of the EBG structure which is constituted in the connection body in the embodiment.
Fig. 19 is a diagram for describing a method of manufacturing the second structure body in the embodiment.
Fig. 20 is a diagram schematically showing the cross-sectional structure of the outermost layer of the first structure body and the second structure body in the embodiment.
Fig. 21 is a diagram schematically showing the cross-sectional structure of the outermost layer of the first structure body and the second structure body in the embodiment.
Fig. 22 is a plan view schematically showing the outermost layer of the first structure body and the second structure body in the embodiment.
Fig. 23 is an equivalent circuit diagram of a unit cell of the EBG structure which is constituted in the connection body in the embodiment.
Fig. 24 is a diagram schematically showing the cross-sectional structure of the outermost layer of the first structure body and the second structure body in the embodiment.
Fig. 25 is a diagram for describing a method of manufacturing the second structure body in the embodiment.
Fig. 26 is a diagram schematically showing the cross-sectional structure of the outermost layer of the first structure body and the second structure body in the embodiment.
Fig. 27 is a perspective view showing an example of an island-shaped conductor of the second structure body in the embodiment.
Fig. 28 is a perspective view schematically showing an example of the EBG structure which is constituted in the connection body in the embodiment.
Fig. 29 is a cross-sectional view schematically showing an example of the EBG structure which is constituted in the connection body in the embodiment.
Fig. 30 is an equivalent circuit diagram of a unit cell of the EBG structure which is constituted in the connection body in the embodiment.
Fig. 31 is a perspective view showing an example of an island-shaped conductor of the second structure body in the embodiment.
Fig. 32 is a perspective view schematically showing an example of the EBG structure which is constituted in the connection body in the embodiment.
Fig. 33 is an equivalent circuit diagram of a unit cell of the EBG structure which is constituted in the connection body in the embodiment.
Fig. 34 is a diagram schematically showing the cross-sectional structure of the outermost layer of the first structure body and the second structure body in the embodiment.
Fig. 35 is a diagram schematically showing the cross-sectional structure of the outermost layer of the first structure body and the second structure body in the embodiment.
Fig. 36 is a diagram schematically showing the cross-sectional structure of the outermost layer of the first structure body and the second structure body in the embodiment.
Fig. 37 is a diagram schematically showing the cross-sectional structure of the outermost layer of the first structure body and the second structure body in the embodiment.
Fig. 38 is a plan view showing an example of a conductor which is provided in the connection body in the embodiment.
Fig. 39 is a plan view showing an example of a conductor which is provided in the connection body in the embodiment.
Fig. 40 is a perspective view schematically showing an example of the EBG structure which is constituted in the connection body in the embodiment.
Fig. 41 is a perspective view schematically showing an example of the EBG structure which is constituted in the connection body in the embodiment.
Fig. 42 is a diagram schematically showing the cross-sectional structure of a comparative example.

### DESCRIPTION OF EMBODIMENTS

Hereinafter, embodiments of the invention will be described using the drawings. In all the drawings, the same constituent elements are denoted by the same reference numerals and description thereof will not be repeated.

### <Embodiment 1>

First, the overall configuration of an electronic apparatus related to this embodiment will be described.

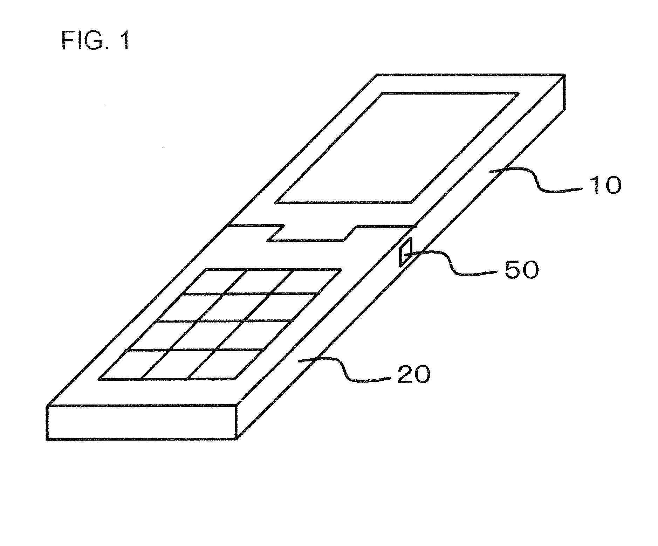

Fig. 1 is a perspective view schematically showing an example of the electronic apparatus related to this embodiment. As shown in the drawing, the electronic apparatus related to this embodiment has a first housing 10 and a second housing 20. The first housing 10 has a first electronic component (electronic circuit), and the second housing 20 has a second electronic component (electronic circuit). The first housing 10 and the second housing 20 are connected to each other by, for example, a hinge 50.

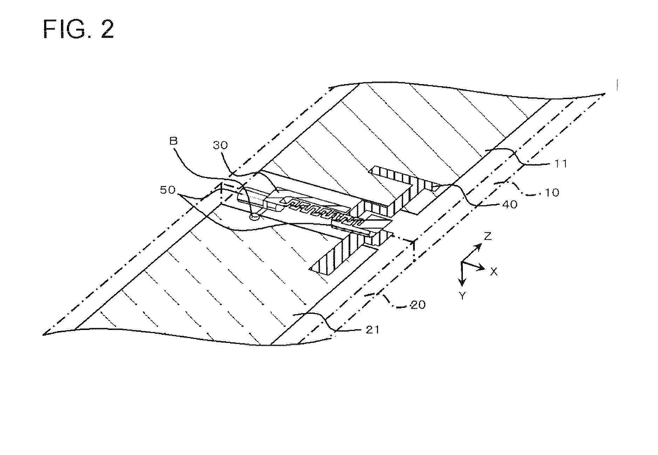

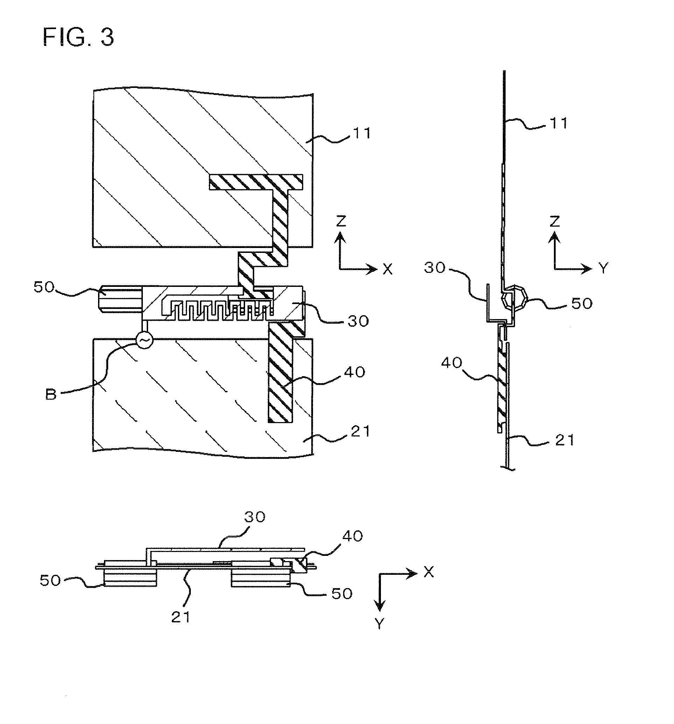

Fig. 2 is a transparent view schematically showing an example of the internal structure of the electronic apparatus shown in Fig. 1. Fig. 3 is a plan view and side view schematically showing the electronic apparatus in a state where the first housing 10 and the second housing 20 are excluded. As shown in the drawings, the electronic apparatus related to this embodiment includes a first electronic component 11 that the first housing 10 has, a second electronic component 21 that the second housing 20 has, an antenna 30, and a connection body 40 which electrically connects the first electronic component 11 and the second electronic component 21 to each other.

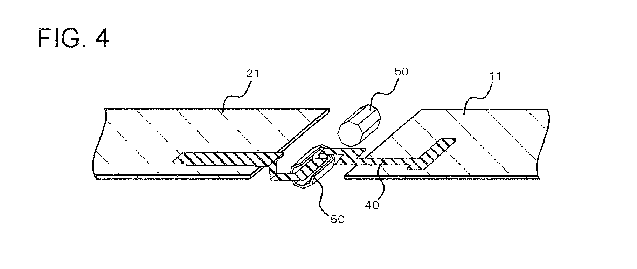

Fig. 4 is a perspective view schematically showing one example in a state where furthermore the antenna 30 is excluded from the electronic apparatus in the state of Fig. 3. As shown in the drawing, the connection body 40 may also pass through the inside of the hinge 50.

Hereinafter, each configuration will be described.

The first housing 10 is provided with the first electronic component 11. Further, the second housing 20 is provided with the second electronic component 21. In this embodiment, the configurations of the first housing 10, the second housing 20, the first electronic component 11, and the second electronic component 21 (the shapes and materials of the housings, the types of the electronic components, or the like) are not particularly limited and any configuration according to the related art is also acceptable.

The antenna 30 is provided at an end portion of the first housing 10. The end portion of the first housing 10 is an end portion in the vicinity along the outer periphery of the first housing 10 when the first housing 10 is seen in a plan view. The antenna 30 is provided at an end portion of the first housing 10 in terms of design taking into account the antenna characteristics. For example, the antenna 30 may also be provided at a position where an end portion of the first housing 10 and an end portion of the second housing 20 are located, as shown in Fig. 2. In such a case, there is a case where the antenna 30 partially or entirely overlaps the hinge 50 when seen in a plan view. In addition, the configuration (the shape, the material, the position at an end portion of the first housing 10, or the like) of the antenna 30 is not particularly limited and any configuration according to the related art is also acceptable.

The connection body 40 electrically connects the first electronic component 11 that the first housing 10 has and the second electronic component 21 that the second housing 20 has, to each other. The connection body 40 having such a function is provided to extend over the first housing 10 and the second housing 20. As the disposition method thereof, there are various methods. However, there is a case where the connection body 40 is provided so as to pass through the end portion of the first housing 10 where the antenna 30 is provided, in terms of design. The expression "pass through the end portion of the first housing 10" means that at least a portion of the connection body 40 overlaps the end portion of the first housing 10 when seen in a plan view.

In the case of the electronic apparatus related to this embodiment, the antenna 30 and the connection body 40 sometimes enter a state of being adjacent to each other in terms of the positional relationship therebetween, as shown in, for example, Fig. 2. Further, there is also a case where the antenna 30 and the connection body 40 overlap each other when seen in a plan view. In such a case, radio waves transmitted from the antenna 30 interfere with a conductor of the connection body 40, thereby generating an electric current, or current noise flowing through a conductor of the connection body 40 affects the antenna 30, whereby there is a concern that antenna characteristics may deteriorate. Therefore, the connection body 40 in this embodiment has a structure for avoiding the above disadvantages. Hereinafter, an example of the structure of the connection body 40 in this embodiment will be described.

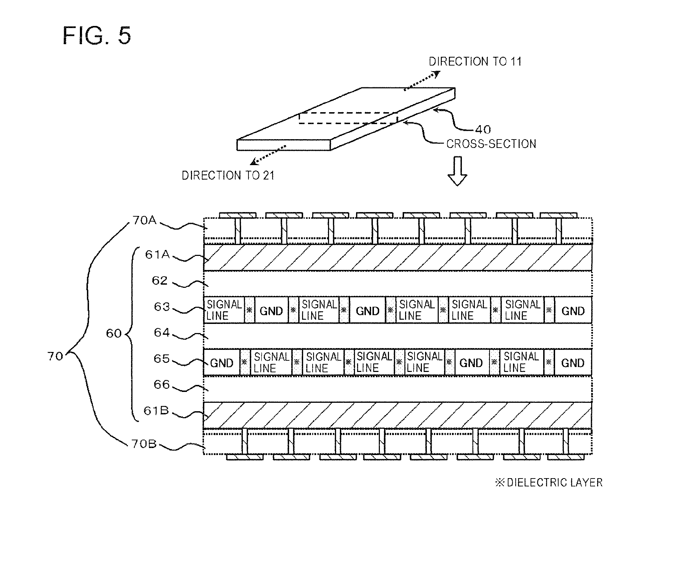

Fig. 5 is a diagram schematically showing an example of the cross-sectional structure of the connection body 40 in this embodiment. As shown in the drawing, the connection body 40 includes a first structure body 60 having a laminated structure and second structure bodies 70 which are provided in contact with outermost layers (61A and 61B) of the first structure body 60.

The first structure body 60 has a laminated structure which includes an electric conductor and a dielectric, and the outermost layers (61A and 61B) become electric conductor layers. The layer configuration of the first structure body 60 is not particularly limited except that the outermost layers (61A and 61B) become electric conductor layers, and the number of layers is also not particularly limited. The first structure body 60 may be a flexible substrate having any configuration according to the related art. As one example of the first structure body 60, for example, a laminated structure is also acceptable in which an electric conductor layer 61A, a dielectric layer 62, a layer 63 which is composed of an electric conductor and an insulator, a dielectric layer 64, a layer 65 which is composed of an electric conductor and an insulator, a dielectric layer 66, and an electric conductor layer 61B are laminated in this order, as shown in Fig. 5. In the case of this configuration, the layer 63 which is composed of an electric conductor and an insulator and the layer 65 which is composed of an electric conductor and an insulator become layers having signal lines. The outermost layers (the electric conductor layers 61A and 61B) may also be layers each formed of a material such as copper, for example, or layers each formed of silver paste. The outermost layers (the electric conductor layers 61A and 61B) may also constitute GND layers.

The second structure body 70 is provided in contact with the outer surface of at least one of the outermost layers (the electric conductor layers 61A and 61B) of the first structure body 60. In the example shown in Fig. 5, second structure bodies 70A and 70B are provided in contact with the respective outer surfaces of two outermost layers (the electric conductor layers 61A and 61B) of the first structure body 60. Further, the second structure bodies 70 may also be provided on the entire outer surfaces of the outermost layers (the electric conductor layers 61A and 61B) of the first structure body 60 and may also be provided at some areas. Favorable positions in a case where the second structure bodies 70 are provided at some areas will be described below. In addition, the expression "be provided on the entire outer surfaces of the outermost layers (the electric conductor layers 61A and 61B)" means that the second structure bodies 70 are provided on the entire surfaces of places where the second structure bodies 70 can be disposed in design, and in a case where other configurations (a configuration for connecting the second structure body 70 to the first electronic component 11 or the second electronic component 21, or the like) are present on the outer surfaces of the outermost layers (the electric conductor layers 61A and 61B), it is acceptable if the second structure bodies 70 are provided on the entire surfaces except for these other configurations.

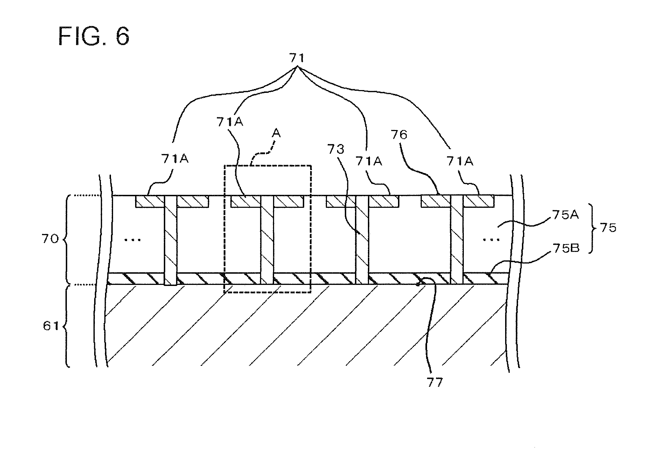

Here, in Fig. 6, a cross-sectional view of an outermost layer 61 of the first structure body 60 and the second structure body 70 is schematically shown. The outermost layer 61 shown in Fig. 6 corresponds to each of the outermost layers 61A and 61B or the like shown in, for example, Fig. 5.

As shown in Fig. 6, the second structure body 70 includes a first conductor 71, a connecting member 73, and a dielectric layer 75.

The dielectric layer 75 is provided in contact with the outermost layer 61 of the first structure body 60. Further, at least a portion of the dielectric layer 75 constitutes an adhesion layer 75B which is adhered to the outermost layer 61 of the first structure body 60. For example, as shown in Fig. 6, the dielectric layer 75 may also be a laminated structure composed of a layer 75A which is formed of a dielectric and the adhesion layer 75B. The layer 75A may also be, for example, a substrate having flexibility. More specifically, the layer 75A may also be, for example, a glass epoxy substrate, a fluorine-containing resin substrate, or the like. The layer 75A may also be a single layer and may also be a multilayer. Next, the adhesion layer 75B can be formed of, for example, an adhesive. As a raw material of the adhesive, it is not particularly limited and, for example, natural rubber, acrylic resin, silicone, or the like can be used. In addition, the thicknesses of the layer 75A and the adhesion layer 75B are a matter of design.

The first conductor 71 is provided over the surface of the dielectric layer 75, that is, a surface 76 on the opposite side to a surface 77 which comes into contact with the outermost layer 61 of the first structure body 60, so as to face the outermost layer 61. In addition, the first conductor 71 may also be provided to face the outermost layer 61 in the inside of the dielectric layer 75. The first conductor 71 has a repeated structure, for example, a periodic structure at least in some areas. As the repeated structure, a structure is conceivable in which a plurality of island-shaped conductors 71A separated from each other is provided repeatedly, for example, periodically, as shown in Fig. 6.

In addition, in the expression "repetition" in the island-shaped conductors 71A, a case where the island-shaped conductors 71A are partially missing is also included. Further, in the expression "periodic", a case where disposition of some of the island-shaped conductors 71A themselves are shifted is also included. That is, even in a case where periodicity in a strict sense is broken, in a case where the island-shaped conductors 71A are repeatedly disposed, since it is possible to obtain characteristics as a metamaterial of an EBG structure (described below) with the island-shaped conductors 71A as some of constituent elements, some defects are allowed in the "periodicity".

A raw material of the island-shaped conductors 71A is not particularly limited and, for example, copper or the like can be selected. The shape of an island shape is also not particularly limited and any shape such as a triangle, a quadrangle, a pentagon, a polygon having more vertices, or a circle can be selected. In addition, it is also possible to repeatedly dispose two or more types of island-shaped conductors 71A different in size and/or shape from each other. In such a case, it is preferable that two or more types of island-shaped conductors 71A be arranged periodically for each type. The size of the island-shaped conductors 71A, the mutual interval between the island-shaped conductors 71A, or the like is determined according to a desired band-gap band which is set in the EBG structure (described below) with the island-shaped conductors 71A as some of constituent elements.

The connecting members 73 are provided in the inside of the dielectric layer 75 and electrically connect some or all of the island-shaped conductors 71A and the outermost layer 61 of the first structure body 60 to each other. That is, the connecting members 73 are exposed at least on the surface 77 (the surface which comes into contact with the outermost layer 61 of the first structure body 60) side of the dielectric layer 75, thereby coming into contact with the outermost layer 61, and also coming into contact with some or all of the island-shaped conductors 71A. In addition, in a case where the connecting members 73 are provided so as to electrically connect some of the island-shaped conductors 71A and the outermost layer 61 to each other, the connecting members 73 may be periodically provided but need not be periodically provided. However, since in a case where the connecting members 73 are periodically provided, the EBG structure (described below) with the connecting members 73 as some of constituent elements causes Bragg reflection, so that a band-gap band broadens, it is preferable that the connecting members 73 be periodically provided. In the expression "periodic" as referred to herein, a case where disposition of some of the connecting members 73 themselves are shifted is also included. Such connecting members 73 can be formed of metal such as copper, aluminum, and stainless steel, for example.

The second structure body 70 in this embodiment is a sheet having the adhesion layer 75B, and the connection body 40 in this embodiment is obtained by sticking the second structure body 70 (the sheet) to the outer surface of the first structure body 60 which is a flexible substrate.

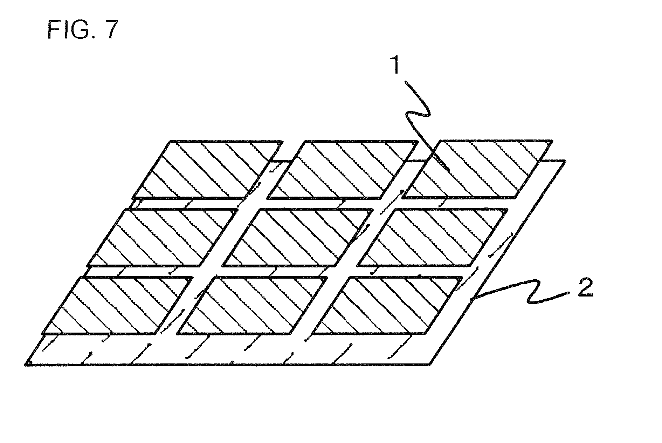

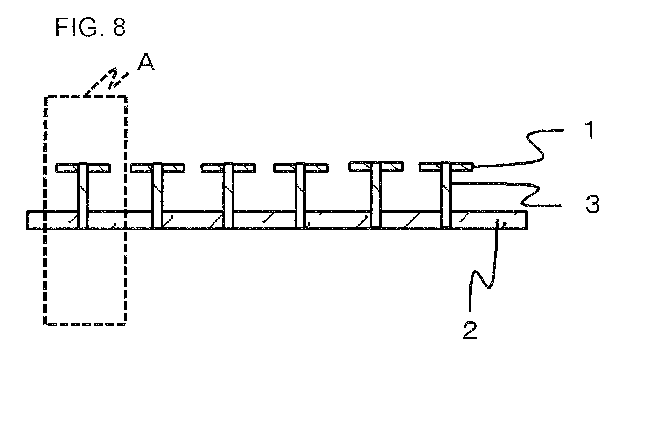

Here, in this embodiment, the EBG structure is constituted by the second structure body 70 and the outermost layer 61 of the first structure body 60. In Figs. 7 and 8, an example of the EBG structure which is constituted by the second structure body 70 in this embodiment and the outermost layer 61 of the first structure body 60 is schematically shown. Fig. 7 is a perspective view schematically showing the configuration of the EBG structure and Fig. 8 is a cross-sectional view of the EBG structure shown in Fig. 7.

The EBG structure shown in Figs. 7 and 8 includes a sheet-shaped conductor 2, a plurality of island-shaped conductors 1 separated from each other, and a plurality of connecting members 3. The sheet-shaped conductor 2 corresponds to the outermost layer 61 of the first structure body 60, the island-shaped conductors 1 correspond to the island-shaped conductors 71A of the second structure body 70, and the connecting members 3 corresponds to the connecting members 73 of the second structure body 70.

The plurality of island-shaped conductors 1 is disposed at areas which overlap the sheet-shaped conductor 2 when seen in a plan view, and at positions away from the sheet-shaped conductor 2, with a dielectric layer (not shown in the drawings) interposed therebetween. Further, the plurality of island-shaped conductors 1 is arranged periodically. The connecting members 3 electrically connect each of the plurality of island-shaped conductors 1 to the sheet-shaped conductor 2. In this EBG structure, a unit cell A thereof is constituted by a single island-shaped conductor 1, the connecting member 3 provided to correspond to the island-shaped conductor 1, and the area facing the island-shaped conductor 1 of the sheet-shaped conductor 2. Then, this unit cell A is disposed repeatedly, for example, periodically, whereby this structure body functions as a metamaterial, for example, an EBG (Electromagnetic Band Gap). This EBG structure is an EBG structure having a so-called mushroom structure.

Here, in the "repetition" of the unit cell A, a case where a portion of a configuration is missing in any unit cell A is also included. Further, in a case where the unit cell A has a two-dimensional array, in the "repetition", a case where the unit cell A is partially missing is also included. Further, in the expression "periodicity", a case where some of constituent elements (the island-shaped conductors 1 and the connecting members 3) are shifted in some of the unit cells A or a case where disposition of some of the unit cells A themselves are shifted is also included. That is, even in a case where periodicity in a strict sense is broken, in a case where the unit cells A are repeatedly disposed, since it is possible to obtain characteristics as the metamaterial, some defects are allowed in the "periodicity". In addition, as a factor in which these defects occur, a case where an interconnection or a via passes between the unit cells A, a case where the unit cell A cannot be disposed due to an existing via or pattern when adding a metamaterial structure to an existing interconnection layout, or a manufacturing error, the case of using the existing via or pattern as a portion of the unit cell A, or the like is conceivable. The above-described premise is the same in all the following embodiments.

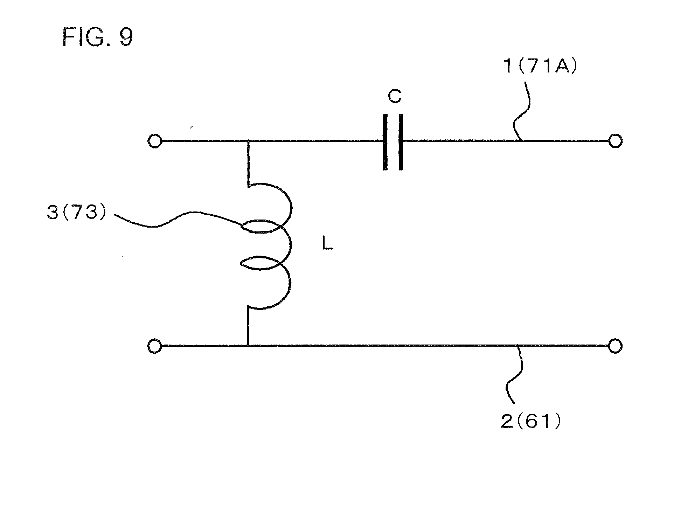

Fig. 9 is an equivalent circuit diagram of the unit cell A shown in Fig. 8. As shown in Fig. 9, the unit cell A is composed of a capacitor C which is provided between adjacent island-shaped conductors 1 and an inductor L which the connecting member 3 creates.

According to this EBG structure, propagation of noise in the surface of the sheet-shaped conductor 2 can be suppressed. Further, adjacent island-shaped conductors 1 form the capacitor C therebetween, whereby propagation of noise in the vicinity of the EBG structure body can be suppressed.

That is, the connection body 40 in this embodiment in which the EBG structure as described above is constituted by the outermost layer 61 of the first structure body 60 and the second structure body 70 can suppress propagation of noise in the surface of the outermost layer 61 of the first structure body 60 at an area where the second structure body 70 is provided and can also suppress propagation of noise in the vicinity of the connection body 40.

Here, in the above-described EBG structure, by regulating the distance between the plurality of island-shaped conductors 1 and the sheet-shaped conductor 2, the thickness of the connecting members 3, the mutual spacing between the plurality of island-shaped conductors 1, or the like, it is possible to regulate a frequency band which becomes a band-gap. That is, it is possible to regulate the frequency of noise, propagation of which is suppressed by the EBG structure.

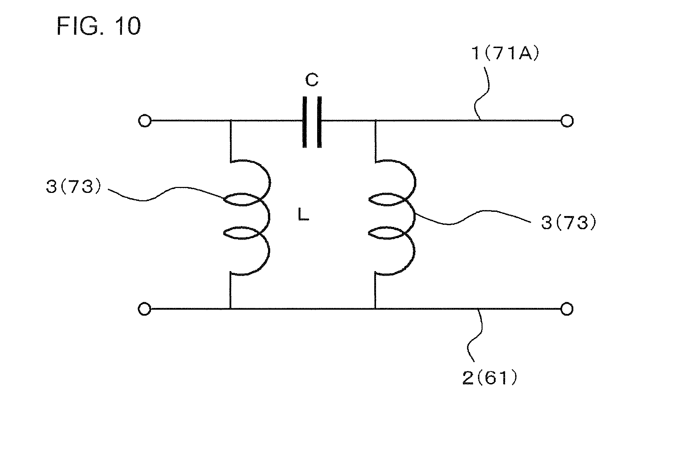

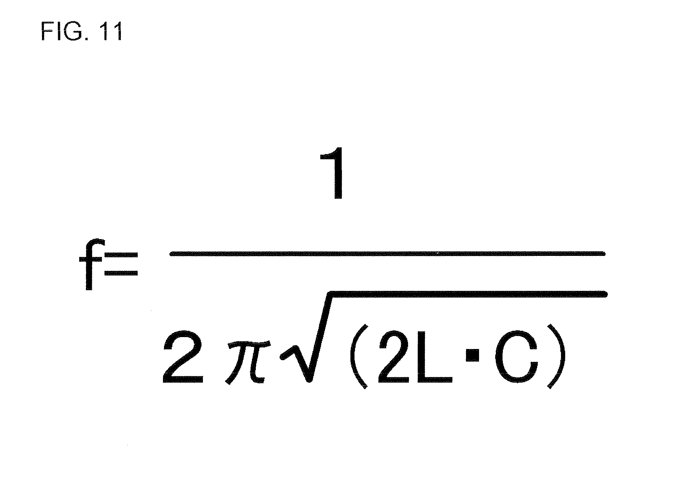

For example, in the case of the EBG structure shown in Fig. 8, two adjacent island-shaped conductors 1, two connecting members 3 respectively connected to the respective island-shaped conductors 1, and the sheet-shaped conductor 2 facing the island-shaped conductors 1 can be shown by an equivalent circuit diagram shown in Fig. 10. A band-gap band f of the EBG structure which is shown by such an equivalent circuit diagram can be calculated by an expression shown in Fig. 11. By appropriately regulating the capacitor C and/or the inductor L constituting the EBG structure in accordance with the expression, it is possible to set a desired f value. More specifically, for example, by changing the distance between adjacent island-shaped conductors 1, changing the size of the island-shaped conductors 1, or changing the length of the connecting members 3, it is possible to appropriately regulate the capacitor C and/or the inductor L, thereby setting a desired f value. In addition, also in the cases of EBG structures having other configurations which are described in the following embodiments, similarly, it is possible to set a desired f value by appropriately regulating the capacitor C and/or the inductor L on the basis of the expression for calculating the band-gap band f which is determined by each EBG structure.

Here, on the premise of the above-described operation and effects by the provision of the second structure body 70, a favorable position where the second structure body 70 is provided will be described.

As described above, the second structure body 70 is provided in contact with the outer surface of at least one of the outermost layers 61 of the first structure body 60. However, considering the above-described operation and effects, it is preferable that the second structure bodies 70 be provided on the outer surfaces of both the outermost layers 61 (61A and 61B in the case of Fig. 5) of the first structure body 60. In addition, in a case where the second structure body 70 is provided only on any one side, it is preferable that the second structure body 70 be provided on the surface which easily interacts with the antenna 30. For example, the second structure body 70 may also be provided on the surface on the side which faces the antenna 30.

Further, as described above, the second structure body 70 may also be provided on the entirety of the outer surface of the outermost layer 61 and may also be provided at some of areas. However, considering the above-described operation and effects, it is preferable that the second structure bodies 70 be provided on the entirety of the outer surface of the outermost layer 61. In addition, in a case where the second structure body 70 is provided at some of areas, it is preferable that the second structure bodies 70 be provided at least at (1) a place closest to a feeding point of the antenna and/or (2) a place which overlaps the antenna when seen in a plan view. A place close to the feeding point is, for example, a point at which a housing (an electronic component) where the feeding point of the antenna is provided and a flexible cable are connected to each other. At that time, the place described above is a suitable case in this embodiment. However, in a case where the connection relationship between the housing (the electronic component), the antenna, and the flexible cable is different, it is not limited thereto. Hereinafter, the reason that it is preferable to provide the second structure body 70 at the place described above will be described.

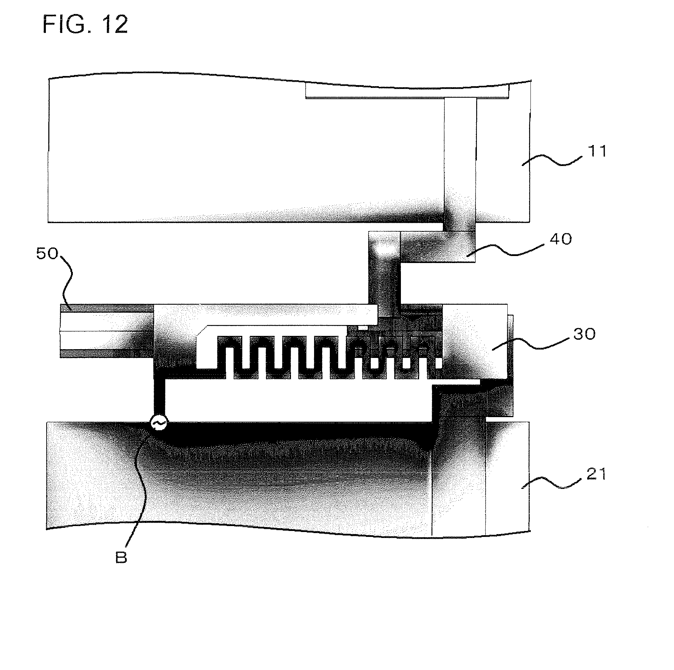

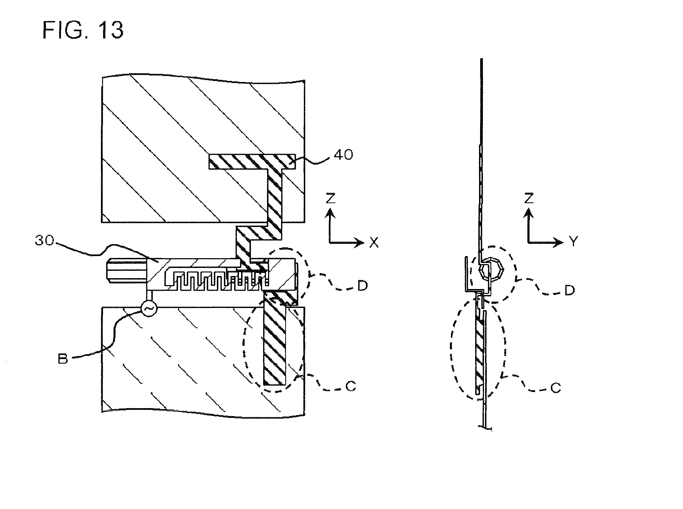

Fig. 12 shows a current distribution when an electric current of 885 MHz has flowed to the antenna 30 in an electronic apparatus in a state where the second structure body 70 is excluded from the connection body 40 in this embodiment. It shows that the blacker the portion in the drawing, the higher the current density. As shown in the drawing, it can be seen that an electric current flows from the antenna 30 to the surface of the connection body 40. In particular, it can be seen that an electric current flows from the place closest to the feeding point (a place indicated by B in the drawing) and a place which overlaps the antenna 30 when seen in a plan view, to the surface of the connection body 40. That is, flow of an electric current from the antenna 30 to the surface of the connection body 40 can be effectively suppressed by constituting the EBG structure having the above-described operation and effects by providing the second structure body 70 at (1) the place closest to the feeding point of the antenna and/or (2) the place which overlaps the antenna when seen in a plan view. For example, the second structure body 70 may also be provided within an area shown by C in Fig. 13, so as to include the place closest to the feeding point (the place indicated by B in the drawing) of the antenna 30. Then, in addition to or in place of this, the second structure body 70 may also be provided within an area shown by D in Fig. 13, so as to include the place which overlaps the antenna 30 when seen in a plan view. In addition, in order to suppress an electric current flowing from the antenna 30 to the connection body 40 by the EBG structure, there is a need to include the frequency of an electric current, propagation of which is desired to be suppressed, in the band-gap band of the EBG structure. That is, in the case of the example shown in Fig. 10, there is a need to include 885 MHz in the band-gap band of the EBG structure. The means is as described above.

According to the electronic apparatus related to this embodiment, by the EBG structure which is formed on the outer surface of the connection body 40, in addition to being able to suppress the movement of an electric current from the antenna 30 to the outer surface of the connection body 40, the movement of noise which is propagated through the outer surface of the connection body 40 (the outer surface of the first structure body 60), to the antenna 30, can be suppressed.

If an unnecessary (unexpected) electric current is generated in the flexible substrate (the connection body 40), since an electric current which is not assumed at the time of design of the antenna flows in the vicinity, it affects the radiation efficiency or the directivity of the antenna 30, causing deterioration of antenna characteristics. In the case of using the structure in this embodiment, since it is possible to prevent an unnecessary (unexpected) electric current from being generated in the flexible substrate (the connection body 40), it is possible to prevent deterioration of antenna characteristics such as the radiation efficiency or the directivity. That is, even in a case where the flexible substrate is disposed in the vicinity of the antenna, deterioration of antenna characteristics due to the flexible substrate can be suppressed.

Further, the flexible substrate (the connection body 40) is connected to an electronic circuit which is enclosed in the housing. However, in the case of using the structure in this embodiment, by preventing an unnecessary electric current from being generated in the flexible substrate (the connection body 40), the effect of preventing even the malfunctions or the like of other circuits is also obtained.

Further, in this embodiment, since the band-gap band of the EBG structure can be regulated, deterioration of the antenna characteristics can be effectively suppressed by regulating the band-gap band of the EBG structure in accordance with a frequency that the electronic apparatus uses. For example, the band-gap band of the EBG structure may also include some or all of frequency bands equal to or more than 700 MHz and equal to or less than 2.3 GHz. If it is in this numerical value range, it becomes possible to include a frequency band which is used in a mobile phone.

In addition, in this embodiment, two or more types of EBG structures different in band-gap band from each other are constituted by the second structure body 70 and the outermost layer 61 of the first structure body 60 and each of the EBG structures may also be disposed repeatedly, for example, periodically. If doing so, it becomes possible to broaden the band-gap band.

In addition, the second structure body 70 in this embodiment is relatively simple in configuration, compared to the second structure bodies 70 having other structures which are described in the following embodiments. For this reason, in addition to being able to reduce the manufacturing process, it is also excellent in terms of the manufacturing cost.

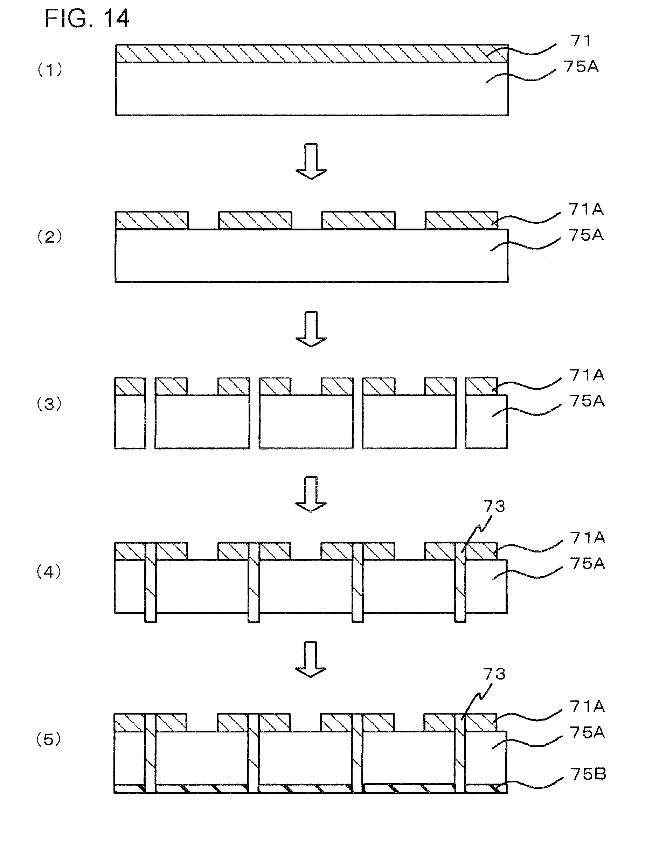

Next, an example of a method of manufacturing the connection body 40 in this embodiment will be described using Fig. 14. Fig. 14 is a cross-sectional view showing an example of the manufacturing process of the connection body 40 in the embodiment.

First, a method of manufacturing the second structure body 70 will be described.

First, as shown in (1), copper foil 71 is formed on a first surface (an upper surface in the drawing) of a substrate (the layer 75A) such as a glass epoxy substrate or a fluorine-containing resin substrate. Next, as shown in (2), a pattern (the plurality of island-shaped conductors 71A separated from each other) is formed by selectively etching a portion of the copper foil 71 by photolithography and etching. Thereafter, as shown in (3), holes passing through the island-shaped conductors 71A and the layer 75A are formed by a drill.

Next, as shown in (4), penetration pins (the connecting members 73) formed of metal such as copper, aluminum, and stainless steel are inserted into the holes formed in (3).

Thereafter, as shown in (5), the adhesion layer 75B is formed on a second surface (a lower surface in the drawing) of the layer 75A. The adhesion layer 75B is formed such that the connecting members 73 pass through the adhesion layer 75B, thereby being exposed. As specific means for forming the adhesion layer 75B in this manner, although it is not particularly limited, the following means is also acceptable. For example, it may also be realized by constituting the length of the connecting member 73 which is inserted in (4), to be a length of an extent that one end is exposed from the second surface (the lower surface in the drawing) of the layer 75A in an inserted state, and then, constituting the adhesion layer 75B by a sheet-shaped adhesive and exposing one end of the connecting member 73 from the surface of the sheet-shaped adhesive (the adhesion layer 75B) by strongly pushing the sheet-shaped adhesive (the adhesion layer 75B) when forming the sheet-shaped adhesive (the adhesion layer 75B) on the second surface of the layer 75A. Otherwise, the connecting member 73 may also be exposed from the surface of the adhesion layer 75B by constituting the adhesion layer 75B by an adhesive having fluidity, applying the adhesive to the second surface (the lower surface in the drawing) of the layer 75A, and then removing the adhesive applied to the surface of the connecting member 73 by using a squeegee. Next, as necessary, a non-conductive surface layer (not shown in the drawing) is provided which covers the plurality of island-shaped conductors 71A separated from each other and the first surface of the layer 75A.

Thereafter, as shown in Fig. 5, the second structure body 70 is stuck at a desired position of the first structure body 60 (the flexible substrate) fabricated according to the related art such that the adhesion layer 75B comes into contact with the outermost layer 61A (or 61B) of the first structure body 60. At this time, the sticking is performed such that the connecting members 73 come into contact with the outermost layer 61A (or 61B) of the first structure body 60.

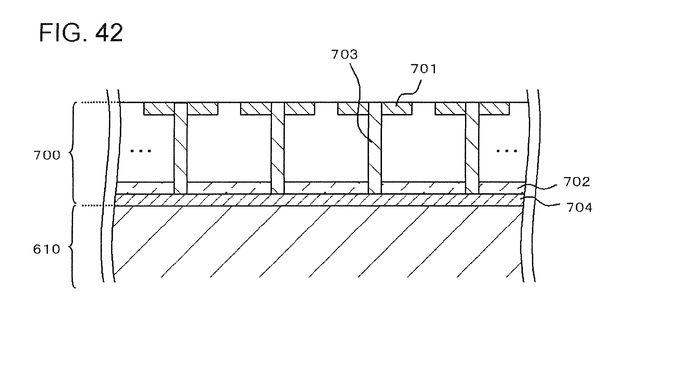

Here, only by simply sticking a sheet having the EBG structure as shown in Figs. 7 and 8 to the outer surface of the first structure body 60 (the flexible substrate), the above-described effects cannot be realized. The reason will be described below using Fig. 42.

Fig. 42 is a cross-sectional view showing a state where a sheet 700 having the EBG structure shown in Figs. 7 and 8 is stuck to the outer surface of a first structure body 610 (a flexible substrate). The sheet 700 shown in Fig. 42 has a sheet-shaped conductor 702, a plurality of island-shaped conductors 701 separated from each other, and a plurality of connecting members 703.

As shown in Fig. 42, usually, the sheet 700 has a layer 704 of an insulating adhesive in order to secure adhesiveness with an adherend. The layer 704 of the adhesive is located between the sheet-shaped conductor 702 and the first structure body 610 (the flexible substrate) in a state where the sheet 700 having the EBG structure is stuck to the first structure body 610 (the flexible substrate), thereby making the sheet-shaped conductor 702 and the first structure body 610 be in a state of being electrically isolated from each other, as shown in Fig. 42. In this manner, in a state where the first structure body 610 (the flexible substrate) and the EBG structure are electrically isolated from each other, it is not possible to suppress propagation of noise in the surface of the first structure body 610 (the flexible substrate).

The electronic apparatus related to this embodiment solves the above-described problem. Specifically, in the electronic apparatus related to this embodiment, as shown in Fig. 6, the outermost layer 61 of the first structure body 60 (the flexible substrate) constitutes a portion of the EBG structure. In such a case, a state is not created where the first structure body 610 (the flexible substrate) and the EBG structure are electrically isolated from each other, as described above.

Here, in the above description, a so-called folding type mobile phone has been described as an example. However, the electronic apparatus related to this embodiment is not limited thereto, and any electronic apparatus which includes a first housing that is provided with a first electronic component, a second housing that is provided with a second electronic component, an antenna which is provided at an end portion of the first housing, and a connection body which electrically connects the first electronic component and the second electronic component to each other, wherein the antenna and the connection body can sometimes come close to each other, corresponds thereto. For example, the electronic apparatus related to this embodiment may also be a so-called sliding type mobile phone.

### <Embodiment 2>

An electronic apparatus related to this embodiment is based on the electronic apparatus related to Embodiment 1 and the configuration of the second structure body 70 is partially different in the two. Since other configurations are the same as those in the electronic apparatus related to Embodiment 1, description thereof will not be repeated here.

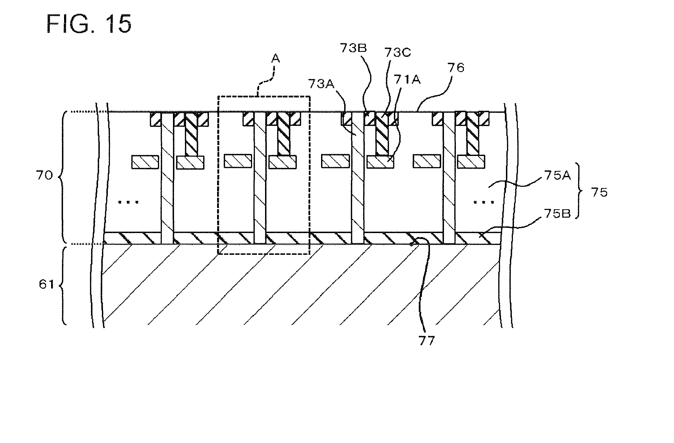

Fig. 15 is a cross-sectional view schematically showing the outermost layer 61 of the first structure body 60 and an example of the second structure body 70 in this embodiment. The second structure body 70 shown in the drawing is based on the second structure body 70 (refer to Fig. 6) in Embodiment 1 and the configuration of the connecting members 73 (73A, 73B, and 73C) is different in the two. Since other configurations are the same as those in Embodiment 1, description thereof will not be repeated here.

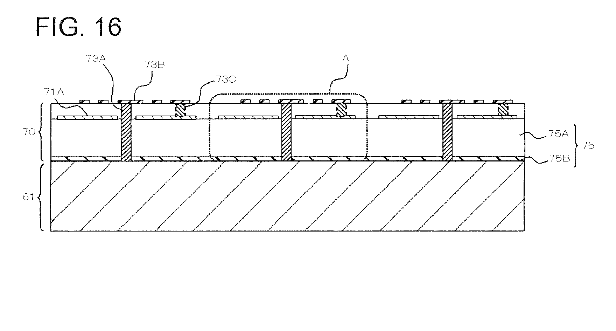

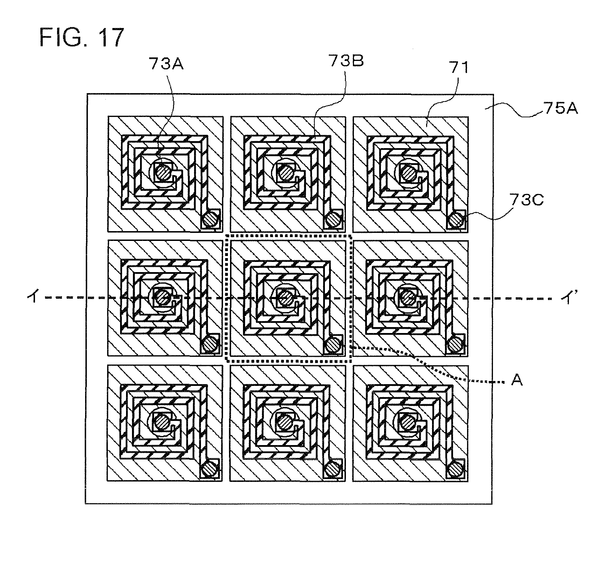

The connecting members 73 in this embodiment are composed of a first conductive connecting member 73A, a second conductive connecting member 73B, and a third conductive connecting member 73C. One end of the first connecting member 73A passes through the surface 77 of the dielectric layer 75 and comes into contact with the outermost layer 61 of the first structure body 60 and also the first connecting member 73A allows conduction to the second connecting member 73B through the other end side. The first connecting member 73A passes through a hole provided at the island-shaped conductor 71A in a non-contact state with the island-shaped conductor 71A. The second connecting member 73B is provided so as to allow conduction to the first connecting member 73A and face the island-shaped conductor 71A. The planar shape of the second connecting member 73B may also be a straight line, may also be a curved line, may also be a spiral shape, and may also be another shape. The third connecting member 73C allows conduction to the second connecting member 73B through one end side and allows conduction to the island-shaped conductor 71A through the other end side extending in a direction to the surface 77 of the dielectric layer 75. Here, an example in a case where the second connecting member 73B has a spiral shape is shown in Figs. 16 and 17. Fig. 16 is a cross-sectional view along line XVI-XVI in Fig. 17, and Fig. 17 is a plan view when Fig. 16 is seen from the top to the bottom in the drawing. In addition, in Figs. 16 and 17, in order to make the configuration clearer, different hatching from that in the other drawings is used.

Here, also in this embodiment as shown in Figs. 15 and 16, the EBG structure is constituted by the outermost layer 61 of the first structure body 60 and the second structure body 70. However, the EBG structure which is constituted in this embodiment is different from the EBG structure described in Embodiment 1.

In the EBG structure which is constituted in this embodiment, the unit cell A thereof is constituted by a single island-shaped conductor 71A, the connecting members 73 (73A, 73B, and 73C) provided to correspond to the island-shaped conductors 71A, and the area facing the island-shaped conductors 71A of the outermost layer 61 of the first structure body 60. This EBG structure is a short stub type EBG structure in which a microstrip line which is formed including the connecting member 73B functions as a short stub. In detail, the connecting member 73A forms inductance. Further, the connecting member 73B is electrically joined to the facing island-shaped conductor 71A, thereby forming a microstrip line with the island-shaped conductor 71A as a return path. One end of the microstrip line becomes a short end due to the third connecting member 73C and is constituted so as to function as a short stub.

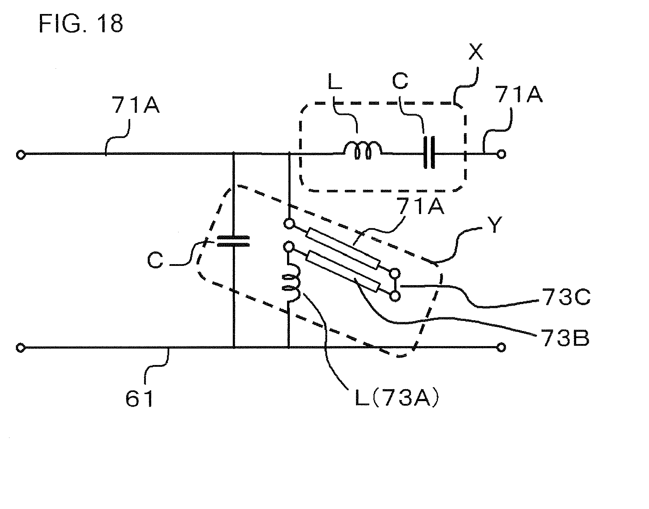

Fig. 18 is an equivalent circuit diagram of the unit cell A shown in Figs. 15 and 16. As shown in Fig. 18, this unit cell A is composed of an impedance section X and an admittance section Y. The impedance section X is composed of a capacitor C which is provided between adjacent island-shaped conductors 71A and an inductor L which the island-shaped conductor 71A creates. The admittance section Y is composed of a capacitor C which the outermost layer 61 of the first structure body 60 and the island-shaped conductor 71A create, an inductor L which the first connecting member 73A creates, and a short stub which is formed including the second connecting member 73B (a transmission line) and the third connecting member 73C.

In general, in the EBG structure, it is known that the impedance section X has capacitance properties and an electromagnetic band gap is created by a frequency domain in which the admittance section Y has inductance properties. In the short stub type EBG structure as shown in Figs. 15 and 16, by lengthening the stub length of the short stub, it is possible to make a frequency band in which the admittance section Y has inductance properties be a low frequency. For this reason, it is possible to make a band-gap band be a low frequency. In the short stub type EBG structure, a stub length is required to make the band-gap band be a low frequency. However, since an area is not necessarily required, it is possible to attain a reduction in the size of the unit cell.

According to this EBG structure, propagation of noise in the surface of the outermost layer 61 of the first structure body 60 can be suppressed and propagation of noise in the vicinity of the connection body 40 can also be suppressed.

That is, according to the electronic apparatus related to this embodiment, by the EBG structure which is formed on the outer surface of the connection body 40, in addition to being able to suppress the movement of an electric current from the antenna 30 to the outer surface of the connection body 40, the movement of noise which is propagated through the outer surface of the connection body 40 (the outer surface of the first structure body 60), to the antenna 30, can be suppressed. For this reason, even in a case where the flexible substrate is disposed in the vicinity of the antenna, deterioration of antenna characteristics due to the flexible substrate can be suppressed.

Further, the flexible substrate (the connection body 40) is connected to an electronic circuit which is enclosed in the housing. However, in the case of using the structure in this embodiment, by preventing an unnecessary electric current from being generated in the flexible substrate (the connection body 40), the effect of preventing even the malfunctions or the like of other circuits is also obtained.

Further, in this embodiment, since the band-gap band of the EBG structure can be regulated, deterioration of the antenna characteristics can be effectively suppressed by regulating the band-gap band of the EBG structure in accordance with a frequency that the electronic apparatus uses. For example, the band-gap band of the EBG structure may also include some or all of frequency bands equal to or more than 700 MHz and equal to or less than 2.3 GHz. If it is in this numerical value range, it becomes possible to include a frequency band which is used in a mobile phone.

In addition, in this embodiment, two or more types of EBG structures different in band-gap band from each other are constituted by the second structure body 70 and the outermost layer 61 of the first structure body 60 and each of the EBG structures may also be disposed repeatedly, for example, periodically. If doing so, it becomes possible to broaden the band-gap band.

In the EBG structure which is constituted by the second structure body 70 in this embodiment, by the configuration of the characteristic connecting members 73 (73A, 73B, and 73C), it is possible to form various inductances L and capacitances C, as shown in Fig. 18. As a result, it becomes possible to obtain the inductor L and the capacitor C which are required to suppress propagation of noise of a desired frequency band, without making the size of the island-shaped conductors 71A or the connecting members 73 (73A, 73B, and 73C) larger than necessary. That is, it becomes possible to make the size of the unit cell A relatively small. In such a case, it becomes possible to increase the number of unit cells A per unit area, so that it becomes possible to more effectively suppress propagation of noise.

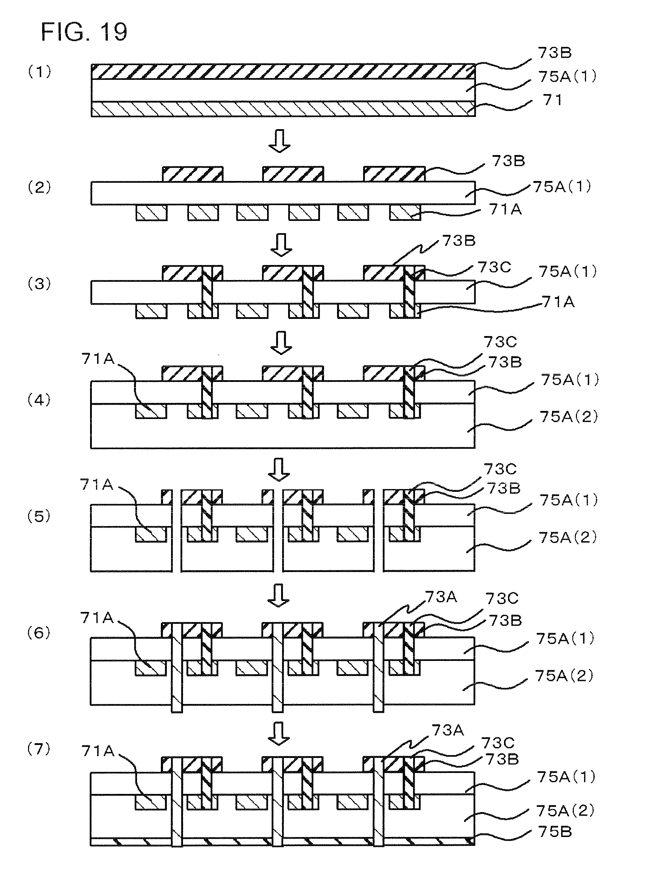

Next, an example of a method of manufacturing the electronic apparatus related to this embodiment will be described using Fig. 19. Fig. 19 is a cross-sectional view showing an example of the manufacturing process of the second structure body 70 in this embodiment.

First, a method of manufacturing the second structure body 70 will be described.

First, as shown in (1), copper foil 73B is formed on a first surface (an upper surface in the drawing) of a substrate (a layer 75A(1)) such as a glass epoxy substrate or a fluorine-containing resin substrate and copper foil 71 is formed on a second surface (a lower surface in the drawing) Next, as shown in (2), a pattern (the plurality of island-shaped conductors 71A separated from each other) is formed by selectively etching a portion of the copper foil 71 by photolithography and etching. Further, a pattern (the second connecting member 73B) is formed by selectively etching a portion of the copper foil 73B by photolithography and etching. In addition, the island-shaped conductor 71A is formed in a pattern provided with a hole for passing the first connecting member 73A therethrough. The hole is formed larger than the diameter of the first connecting member 73A.

Thereafter, a state shown in (3) is obtained by forming holes passing through the second connecting members 73B, the layer 75A(1), and the island-shaped conductors 71A by a drill and inserting penetration pins (the third connecting members 73C) formed of metal such as copper, aluminum, and stainless steel into the holes.

Next, as shown in (4), a dielectric layer 75A(2) is further formed over a second surface (a lower surface in the drawing) of the layer 75A(1). For example, it may also be realized by preparing a new substrate (the layer 75A(2)) having flexibility, such as a glass epoxy substrate or a fluorine-containing resin substrate, and sticking a first surface (an upper surface in the drawing) of the substrate (the layer 75A(2)) to the second surface (the lower surface in the drawing) of the layer 75A(1). In this manner, in this embodiment, the island-shaped conductor 71A (the first conductor) is provided in the inside of a dielectric layer which is constituted by the layers 75A(1) and 75A(2).

Thereafter, as shown in (5), holes passing through the second connecting members 73B, the layers 75A(1) and 75A(2), and the island-shaped conductors 71A are formed using a drill. This hole has a smaller diameter than the hole provided in the island-shaped conductor 71A in (2) and is formed by making a drill perforate so as to pass through the hole in a non-contact state with the island-shaped conductor 71A. Thereafter, as shown in (6), penetration pins (the first connecting members 73A) formed of metal such as copper, aluminum, and stainless steel are inserted into the holes formed in (5).

Thereafter, as shown in (7), the adhesion layer 75B is formed on a second surface (a lower surface in the drawing) of the layer 75A(2). This adhesion layer 75B is formed such that the connecting members 73A pass through the adhesion layer 75B, thereby being exposed. As specific means for forming the adhesion layer 75B in this manner, the same means as the means described in Embodiment 1 can be used. Next, as necessary, a non-conductive surface layer (not shown in the drawing) is provided which covers the second connecting members 73B and the first surface of the layer 75A(1).

Thereafter, as shown in Fig. 15, the second structure body 70 is stuck at a desired position of the first structure body 60 (the flexible substrate) fabricated according to the related art such that the adhesion layer 75B comes into contact with the outermost layer 61A (or 61B) of the first structure body 60. At this time, the sticking is performed such that the first connecting members 73A come into contact with the outermost layer 61A (or 61B) of the first structure body 60.

### <Embodiment 3>

An electronic apparatus related to this embodiment is based on the electronic apparatus related to Embodiment 1 and the configuration of the second structure body 70 is partially different in the two. Since other configurations are the same as those in the electronic apparatus related to Embodiment 1, description thereof will not be repeated here.

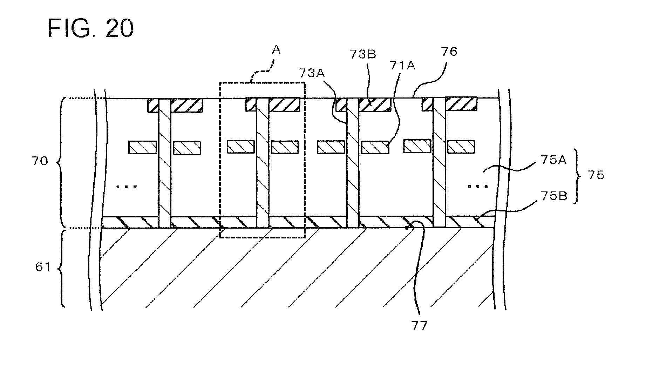

Fig. 20 is a cross-sectional view schematically showing the outermost layer 61 of the first structure body 60 and an example of the second structure body 70 in the embodiment. The second structure body 70 shown in the drawing is based on the second structure body 70 in Embodiment 1 and the configuration of the connecting members 73 (73A and 73B) is different in the two. Since other configurations are the same as those in Embodiment 1, description thereof will not be repeated here.

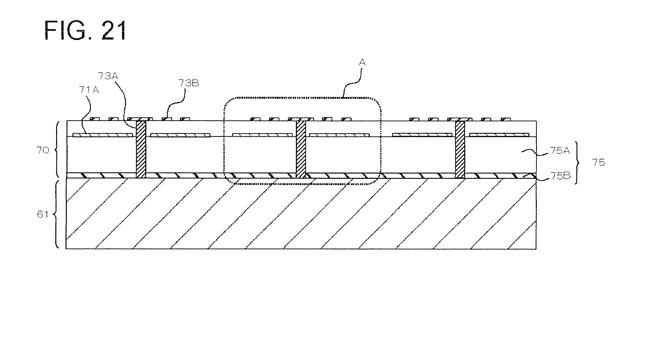

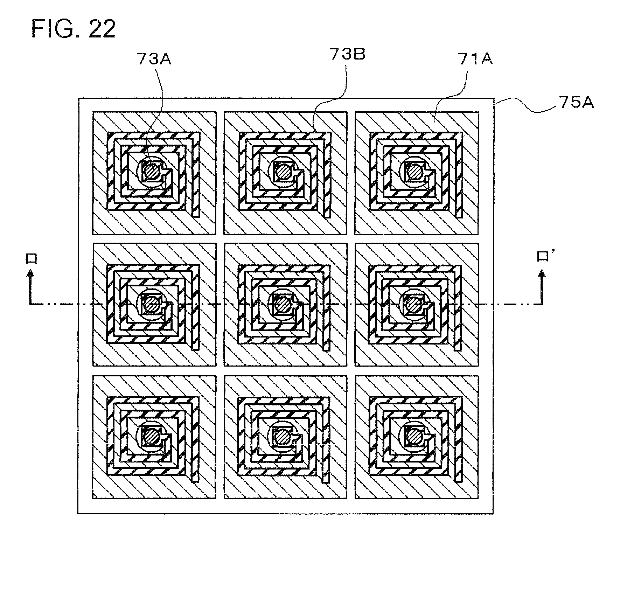

The connecting member 73 in this embodiment is composed of a first conductive connecting member 73A and a second conductive connecting member 73B. One end of the first connecting member 73A passes through the surface 77 of the dielectric layer 75 and comes into contact with the outermost layer 61 of the first structure body 60 and also the first connecting member 73A allows conduction to the second connecting member 73B through the other end side. The first connecting member 73A passes through a hole provided in the island-shaped conductor 71A in a non-contact state with the island-shaped conductor 71A. The second connecting member 73B is provided so as to allow conduction to the first connecting member 73A and face the island-shaped conductor 71A. The planar shape of the second connecting member 73B may also be a straight line, may also be a curved line, may also be a spiral shape, and may also be another shape. The other end of the second connecting member 73B becomes an open end. Here, an example in a case where the second connecting member 73B has a spiral shape is shown in Figs. 21 and 22. Fig. 21 is a cross-sectional view along line XXI-XXI in Fig. 22, and Fig. 22 is a plan view when Fig. 21 is seen from the top to the bottom in the drawing. In addition, in Figs. 21 and 22, in order to make the configuration clearer, different hatching from that in the other drawings is used.

Here, also in this embodiment as shown in Figs. 20 and 21, the EBG structure is constituted by the outermost layer 61 of the first structure body 60 and the second structure body 70. However, the EBG structure which is constituted in this embodiment is different from the EBG structures described in Embodiment 1 and Embodiment 2.

In the EBG structure which is constituted in this embodiment, the unit cell A thereof is constituted by a single island-shaped conductor 71A, the connecting members 73 (73A and 73B) provided to correspond to the island-shaped conductor 71A, and the area facing the island-shaped conductor 71A of the outermost layer 61 of the first structure body 60. This EBG structure is an open stub type EBG structure in which a microstrip line which is formed including the connecting member 73B functions as an open stub. In detail, the connecting member 73A forms inductance. Further, the connecting member 73B is electrically joined to the facing island-shaped conductor 71A, thereby forming a microstrip line with the island-shaped conductor 71A as a return path. One end of the microstrip line becomes an open end and is constituted so as to function as an open stub.

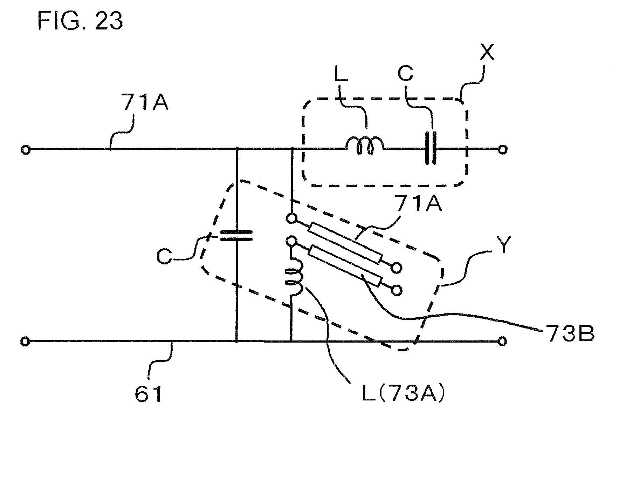

Fig. 23 is an equivalent circuit diagram of the unit cell A shown in Figs. 20 and 21. As shown in Fig. 23, this unit cell A is composed of an impedance section X and an admittance section Y. The impedance section X is composed of a capacitor C which is provided between adjacent island-shaped conductors 71A and an inductor L which the island-shaped conductor 71A creates. The admittance section Y is composed of a capacitor C which the outermost layer 61 of the first structure body 60 and the island-shaped conductor 71A create, an inductor L which the first connecting member 73A creates, and an open stub which is formed including the second connecting member 73B (a transmission line).

In general, in the EBG structure, it is known that the impedance section X has capacitance properties and an electromagnetic band gap is created by a frequency domain in which the admittance section Y has inductance properties. In the open stub type EBG structure as shown in Figs. 20 and 21, by lengthening the stub length of the open stub, it is possible to make a frequency band in which the admittance section Y has inductance properties be a low frequency. For this reason, it is possible to make a band-gap band be a low frequency. In the open stub type EBG structure, a stub length is required to make the band-gap band be a low frequency. However, since an area is not necessarily required, it is possible to attain a reduction in the size of the unit cell.

According to this EBG structure, propagation of noise in the surface of the outermost layer 61 of the first structure body 60 can be suppressed and propagation of noise in the vicinity of the connection body 40 can also be suppressed.

That is, according to the electronic apparatus related to this embodiment, by the EBG structure which is formed on the outer surface of the connection body 40, in addition to being able to suppress the movement of an electric current from the antenna 30 to the outer surface of the connection body 40, the movement of noise which is propagated through the outer surface of the connection body 40 (the outer surface of the first structure body 60), to the antenna 30, can be suppressed. For this reason, even in a case where the flexible substrate is disposed in the vicinity of the antenna, deterioration of antenna characteristics due to the flexible substrate can be suppressed.

Further, the flexible substrate (the connection body 40) is connected to an electronic circuit which is enclosed in the housing. However, in the case of using the structure in this embodiment, by preventing an unnecessary electric current from being generated in the flexible substrate (the connection body 40), the effect of preventing even the malfunctions or the like of other circuits is also obtained.

Further, in this embodiment, since the band-gap band of the EBG structure can be regulated, deterioration of the antenna characteristics can be effectively suppressed by regulating the band-gap band of the EBG structure in accordance with a frequency that the electronic apparatus uses. For example, the band-gap band of the EBG structure may also include some or all of frequency bands equal to or more than 700 MHz and equal to or less than 2.3 GHz. If it is in this numerical value range, it becomes possible to include a frequency band which is used in a mobile phone.

In addition, in this embodiment, two or more types of EBG structures different in band-gap band from each other are constituted by the second structure body 70 and the outermost layer 61 of the first structure body 60 and each of the EBG structures may also be disposed repeatedly, for example, periodically. If doing so, it becomes possible to broaden the band-gap band.

In the EBG structure which is constituted by the second structure body 70 in this embodiment, by the configuration of the characteristic connecting members 73 (73A and 73B), it is possible to form various inductances L and capacitances C, as shown in Fig. 23. As a result, it becomes possible to obtain the inductor L and the capacitor C which are required to suppress propagation of noise of a desired frequency band, without making the size of the island-shaped conductors 71A or the connecting members 73 (73A and 73B) larger than necessary. That is, it becomes possible to make the size of the unit cell A relatively small. In such a case, it becomes possible to increase the number of unit cells A per unit area, so that it becomes possible to more effectively suppress propagation of noise.

A method of manufacturing the electronic apparatus related to this embodiment can be realized according to the method of manufacturing the electronic apparatus described in Embodiment 2. Therefore, description thereof will not be repeated here.

### <Embodiment 4>

An electronic apparatus related to this embodiment is based on the electronic apparatus related to Embodiment 1 and the configuration of the second structure body 70 is partially different in the two. Since other configurations are the same as those in the electronic apparatus related to Embodiment 1, description thereof will not be repeated here.

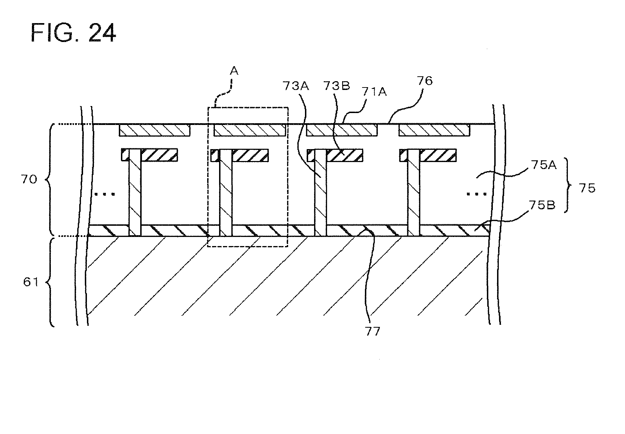

Fig. 24 is a cross-sectional view schematically showing the outermost layer 61 of the first structure body 60 and an example of the second structure body 70 in this embodiment. The second structure body 70 shown in the drawing is based on the second structure body 70 (refer to Fig. 6) in Embodiment 1 and the configuration of the connecting members 73 (73A and 73B) is different in the two. Since other configurations are the same as those in Embodiment 1, description thereof will not be repeated here.

The connecting member 73 in this embodiment is composed of a first conductive connecting member 73A and a second conductive connecting member 73B. One end of the first connecting member 73A passes through the surface 77 of the dielectric layer 75 and comes into contact with the outermost layer 61 of the first structure body 60 and also the first connecting member 73A allows conduction to the second connecting member 73B through the other end side. The first connecting member 73A does not come into contact with the island-shaped conductor 71A. The second connecting member 73B is provided so as to allow conduction to the first connecting member 73A and face the island-shaped conductor 71A. The planar shape of the second connecting member 73B may also be a straight line, may also be a curved line, may also be a spiral shape, and may also be another shape. The other end of the second connecting member 73B becomes an open end.

Here, also in this embodiment as shown in Fig. 24, the EBG structure is constituted by the outermost layer 61 of the first structure body 60 and the second structure body 70. However, the EBG structure which is constituted in this embodiment is different from the EBG structures described in Embodiment 1 to Embodiment 3.

In the EBG structure which is constituted in this embodiment, the unit cell A thereof is constituted by a single island-shaped conductor 71A, the connecting members 73 (73A and 73B) provided to correspond to the island-shaped conductor 71A, and the area facing the island-shaped conductor 71A of the outermost layer 61 of the first structure body 60. This EBG structure is an open stub type EBG structure in which a microstrip line which is formed including the connecting member 73B functions as an open stub. In detail, the connecting member 73A forms inductance. Further, the connecting member 73B is electrically joined to the facing island-shaped conductor 71A, thereby forming a microstrip line with the island-shaped conductor 71A as a return path. One end of the microstrip line becomes an open end and is constituted so as to function as an open stub.

An equivalent circuit diagram of the unit cell A shown in Fig. 24 is the same as the equivalent circuit diagram (Fig. 23) described in Embodiment 3. Therefore, description thereof will not be repeated here.

According to this EBG structure, propagation of noise in the surface of the outermost layer 61 of the first structure body 60 can be suppressed and propagation of noise in the vicinity of the connection body 40 can also be suppressed.

That is, according to the electronic apparatus related to this embodiment, by the EBG structure which is formed on the outer surface of the connection body 40, in addition to being able to suppress the movement of an electric current from the antenna 30 to the outer surface of the connection body 40, the movement of noise which is propagated through the outer surface of the connection body 40 (the outer surface of the first structure body 60), to the antenna 30, can be suppressed. For this reason, even in a case where the flexible substrate is disposed in the vicinity of the antenna, deterioration of antenna characteristics due to the flexible substrate can be suppressed.

Further, the flexible substrate (the connection body 40) is connected to an electronic circuit which is enclosed in the housing. However, in the case of using the structure in this embodiment, by preventing an unnecessary electric current from being generated in the flexible substrate (the connection body 40), the effect of preventing even the malfunctions or the like of other circuits is also obtained.

Further, in this embodiment, since the band-gap band of the EBG structure can be regulated, deterioration of the antenna characteristics can be effectively suppressed by regulating the band-gap band of the EBG structure in accordance with a frequency that the electronic apparatus uses. For example, the band-gap band of the EBG structure may also include some or all of frequency bands equal to or more than 700 MHz and equal to or less than 2.3 GHz. If it is in this numerical value range, it becomes possible to include a frequency band which is used in a mobile phone.

In addition, in this embodiment, two or more types of EBG structures different in band-gap band from each other are constituted by the second structure body 70 and the outermost layer 61 of the first structure body 60 and each of the EBG structures may also be disposed repeatedly, for example, periodically. If doing so, it becomes possible to broaden the band-gap band.

In the EBG structure which is constituted by the second structure body 70 in this embodiment, by the configuration of the characteristic connecting members 73 (73A and 73B) , it is possible to form various inductances L and capacitances C, as shown in Fig. 23. As a result, it becomes possible to obtain the inductor L and the capacitor C which are required to suppress propagation of noise of a desired frequency band, without making the size of the island-shaped conductors 71A or the connecting members 73 (73A and 73B) larger than necessary. That is, it becomes possible to make the size of the unit cell A relatively small. In such a case, it becomes possible to increase the number of unit cells A per unit area, so that it becomes possible to more effectively suppress propagation of noise.

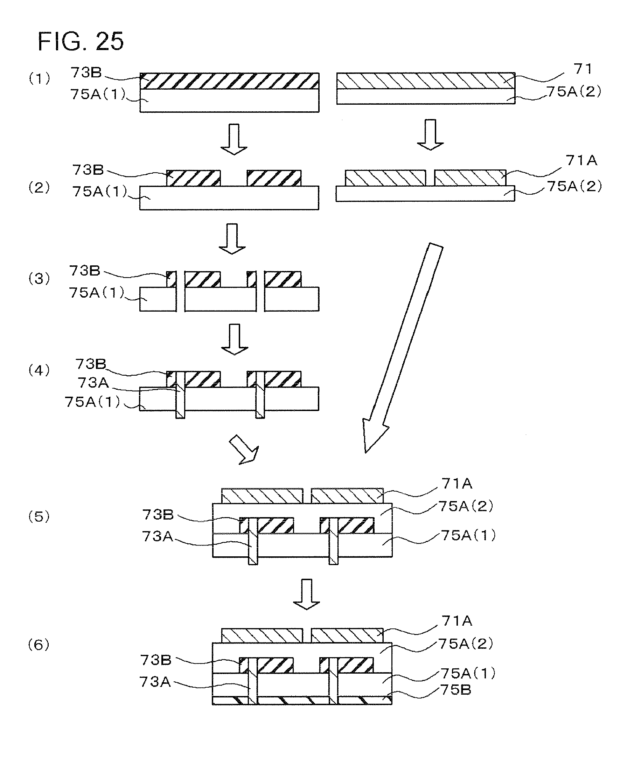

Next, an example of a method of manufacturing the electronic apparatus related to this embodiment will be described using Fig. 25. Fig. 25 is a cross-sectional view showing an example of the manufacturing process of the second structure body 70 in this embodiment.

First, a method of manufacturing the second structure body 70 will be described.

First, as shown in (1), copper foil 73B is formed on a first surface (an upper surface in the drawing) of a substrate (a layer 75A(1)) such as a glass epoxy substrate or a fluorine-containing resin substrate. Further, copper foil 71 is formed on a first surface (an upper surface in the drawing) of another substrate (a layer 75A(2)) having flexibility, such as a glass epoxy substrate or a fluorine-containing resin substrate. Next, as shown in (2), a pattern (the second connecting member 73B) is formed by selectively etching a portion of the copper foil 73B by photolithography and etching. Further, a pattern (the plurality of island-shaped conductors 71A separated from each other) is formed by selectively etching a portion of the copper foil 71 by photolithography and etching.

Thereafter, as shown in (3), holes which pass through the second connecting members 73B and the layer 75A(1) are formed by a drill. Next, as shown in (4), penetration pins (the first connecting members 73A) formed of metal such as copper, aluminum, and stainless steel are inserted into the holes formed in (3).

Thereafter, as shown in (5), a second surface (a lower surface in the drawing) of the layer 75A(2) is stuck to a first surface (an upper surface in the drawing) of the layer 75A(1) so as to come into contact with the first surface. Next, as shown in (6), the adhesion layer 75B is formed on a second surface (a lower surface in the drawing) of the layer 75A(1). This adhesion layer 75B is formed such that the first connecting members 73A pass through the adhesion layer 75B, thereby being exposed. As specific means for forming the adhesion layer 75B in this manner, the same means as the means described in Embodiment 1 can be used. Next, as necessary, a non-conductive surface layer (not shown in the drawing) is provided which covers the plurality of island-shaped conductors 71A separated from each other and the first surface of the layer 75A(2).

Thereafter, as shown in Fig. 24, the second structure body 70 is stuck at a desired position of the first structure body 60 (the flexible substrate) fabricated according to the related art such that the adhesion layer 75B comes into contact with the outermost layer 61A (or 61B) of the first structure body 60. At this time, the sticking is performed such that the first connecting members 73A come into contact with the outermost layer 61A (or 61B) of the first structure body 60.

### <Embodiment 5>

An electronic apparatus related to this embodiment is based on the electronic apparatus related to Embodiment 1 and the configuration of the second structure body 70 is partially different in the two. Since other configurations are the same as those in the electronic apparatus related to Embodiment 1, description thereof will not be repeated here.

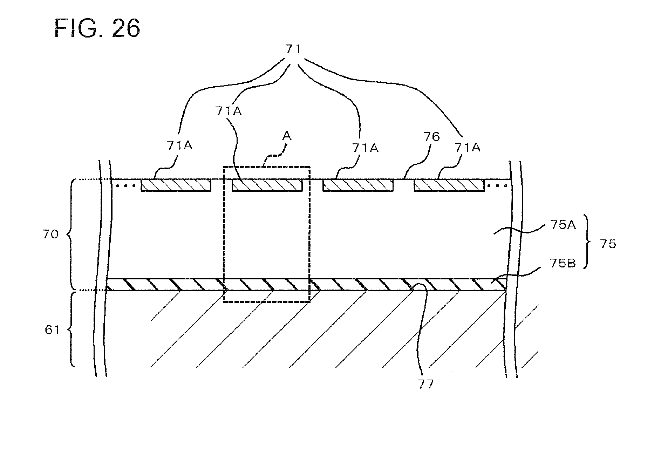

Fig. 26 is a cross-sectional view schematically showing the outermost layer 61 of the first structure body 60 and an example of the second structure body 70 in this embodiment. The second structure body 70 in this embodiment includes the dielectric layer 75, and the first conductor 71 which is formed over the surface 76 (the surface 76 on the opposite side to the surface 77 which comes into contact with the outermost layer 61 of the first structure body 60) on one side of the dielectric layer 75 and has a repeated structure, for example, a periodic structure at least in some areas.

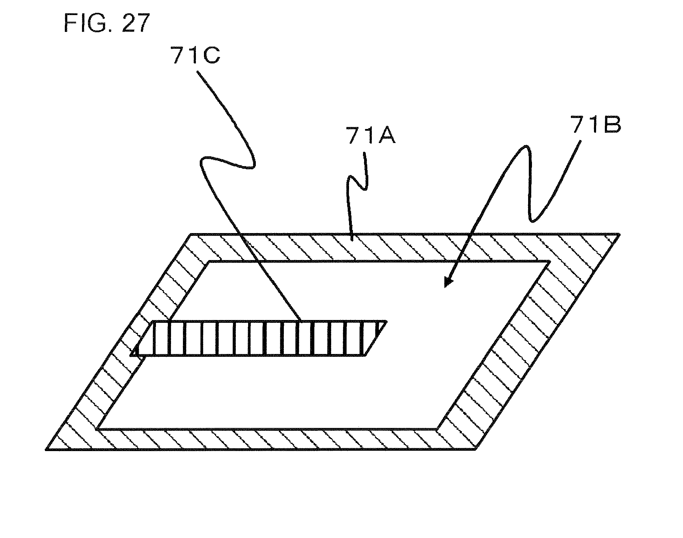

As the repeated structure of the first conductor 71, a structure is conceivable in which the plurality of island-shaped conductors 71A separated from each other is provided repeatedly, for example, periodically. Then, at some or all of the plurality of island-shaped conductors 71A, openings 71B are provided, as shown in an enlarged perspective view of Fig. 27. In a case where the openings 71B are provided at some of island-shaped conductors 71A, it is preferable that the openings 71B be provided periodically. In the opening 71B, an interconnection 71C, one end of which is electrically connected to the island-shaped conductor 71A, is provided. The size of the opening 71B, the length and thickness of the interconnection 71C, or the like is a matter of design which is determined according to the frequency of noise, propagation of which is suppressed. The first conductor 71 is provided to face the outermost layer 61 of the first structure body 60. In addition, the first conductor 71 may also be provided to face the outermost layer 61 of the first structure body 60 in the inside of the dielectric layer 75.

A portion of the dielectric layer 75 is constituted by the adhesion layer 75B which is adhered to the outermost layer 61 of the first structure body 60.

Here, also in this embodiment as shown in Figs. 26 and 27, the EBG structure is constituted by the outermost layer 61 of the first structure body 60 and the second structure body 70. However, the EBG structure which is constituted in this embodiment is different from the EBG structures described in Embodiments 1 to 4.

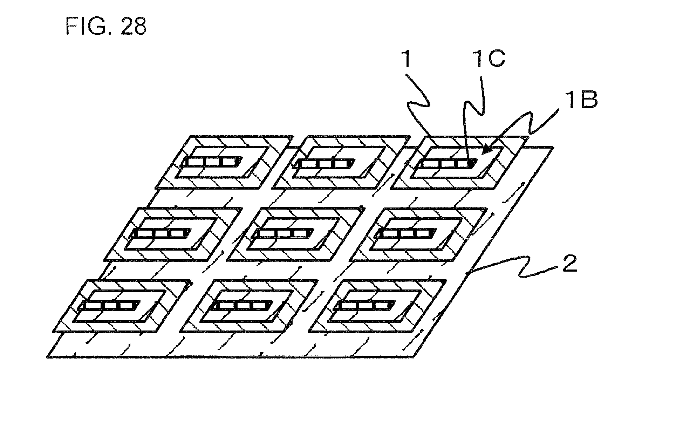

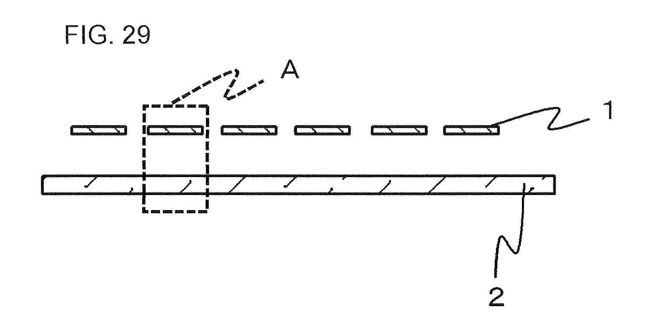

In Figs. 28 and 29, the EBG structure which is constituted by the outermost layer 61 of the first structure body 60 and the second structure body 70 in this embodiment is schematically shown. Fig. 28 is a perspective view schematically showing the configuration of the EBG structure and Fig. 29 is a side view of the EBG structure shown in Fig. 28.

The EBG structure shown in Figs. 28 and 29 includes a sheet-shaped conductor 2, a plurality of island-shaped conductors 1 separated from each other, openings 1B each provided at the island-shaped conductor 1, and interconnections 1C each provided in the openings 1B. The plurality of island-shaped conductors 1 is disposed at areas which overlap the sheet-shaped conductor 2 when seen in a plan view, and at positions away from the sheet-shaped conductor 2, with a dielectric layer (not shown in the drawings) interposed therebetween. Further, the plurality of island-shaped conductors 1 is arranged periodically. At the plurality of island-shaped conductors 1, the openings 1B are provided, and in each of the openings 1B, the interconnection 1C, one end of which is electrically connected to the island-shaped conductor 1, is provided. The interconnection 1C functions as an open stub, and the portion facing the interconnection 1C of the sheet-shaped conductor 2 and the interconnection 1C form a transmission line, for example, a microstrip line.

In this EBG structure body, the unit cell A thereof is constituted by a single island-shaped conductor 1, the interconnection 1C provided in the opening 1B of the island-shaped conductor 1, and the area facing them of the sheet-shaped conductor 2. This unit cell A is periodically disposed, whereby this structure body functions as a metamaterial, for example, an EBG. In the example shown in Figs. 28 and 29, the unit cell A has a two-dimensional array when seen in a plan view.

A plurality of unit cells A has structures equal to as each other and is disposed in the same direction. The island-shaped conductor 1 and the opening 1B each have a square shape and are disposed such that the centers thereof overlap each other. The interconnection 1C extends approximately perpendicular to one side of the opening 1B from approximately the center of the side.

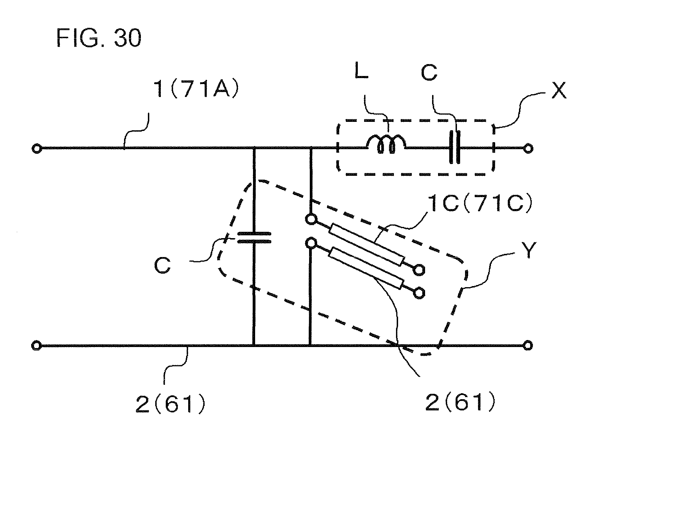

Fig. 30 is an equivalent circuit diagram of the unit cell A shown in Figs. 28 and 29. As shown in Fig. 30, a capacitor C is formed between the sheet-shaped conductor 2 and the island-shaped conductor 1. Further, a capacitor C is also formed between adjacent island-shaped conductors 1. Then, in the island-shaped conductor 1 having the opening 1B, an inductor L is formed.

Further, as described above, the interconnection 1C functions as an open stub and the portion facing the interconnection 1C of the sheet-shaped conductor 2 and the interconnection 1C form a transmission line, for example, a microstrip line. The other end of the transmission line becomes an open end.

According to this EBG structure, propagation of noise in the surface of the sheet-shaped conductor 2 can be suppressed. Further, adjacent island-shaped conductors 1 form the capacitor C therebetween, whereby propagation of noise in the vicinity of the EBG structure body can be suppressed.

The connection body 40 in this embodiment in which the EBG structure as described above is constituted by the outermost layer 61 of the first structure body 60 and the second structure body 70 can suppress propagation of noise in the surface of the outermost layer 61 of the first structure body 60 at an area where the second structure body 70 is provided and can also suppress propagation of noise in the vicinity of the connection body 40.

According to the electronic apparatus related to this embodiment having such a connection body 40, by the EBG structure which is formed on the outer surface of the connection body 40, in addition to being able to suppress the movement of an electric current from the antenna 30 to the outer surface of the connection body 40, the movement of noise which is propagated through the outer surface of the connection body 40 (the outer surface of the first structure body 60), to the antenna 30, can be suppressed. That is, even in a case where the flexible substrate is disposed in the vicinity of the antenna, deterioration of antenna characteristics due to the flexible substrate can be suppressed.

Further, the flexible substrate (the connection body 40) is connected to an electronic circuit which is enclosed in the housing. However, in the case of using the structure in this embodiment, by preventing an unnecessary electric current from being generated in the flexible substrate (the connection body 40), the effect of preventing even the malfunctions or the like of other circuits is also obtained.

Further, in this embodiment, since the band-gap band of the EBG structure can be regulated, deterioration of the antenna characteristics can be effectively suppressed by regulating the band-gap band of the EBG structure in accordance with a frequency that the electronic apparatus uses. For example, the band-gap band of the EBG structure may also include some or all of frequency bands equal to or more than 700 MHz and equal to or less than 2.3 GHz. If it is in this numerical value range, it becomes possible to include a frequency band which is used in a mobile phone.

In addition, in this embodiment, two or more types of EBG structures different in band-gap band from each other are constituted by the second structure body 70 and the outermost layer 61 of the first structure body 60 and each of the EBG structures may also be disposed repeatedly, for example, periodically. If doing so, it becomes possible to broaden the band-gap band.

Since the second structure body 70 in this embodiment does not have the connecting members 73 unlike the second structure bodies 70 in Embodiments 1 to 4, the second structure body 70 in this embodiment need not be provided with means for securing conduction between the connecting members 73 and the outermost layer 61 of the first structure body 60. As a result, quality stability becomes high.

Next, an example of a method of manufacturing the electronic apparatus related to this embodiment will be described.

First, a method of manufacturing the second structure body 70 will be described.

In the second structure body 70 in this embodiment, after copper foil 71 is formed on a first surface of a substrate (the layer 75A) such as a glass epoxy substrate or a fluorine-containing resin substrate, as shown in (1) of Fig. 14, a pattern (the plurality of island-shaped conductors 71A separated from each other) is formed by selectively etching a portion of the copper foil 71 by photolithography and etching, as shown in (2). Due to this photolithography and etching, the island-shaped conductor 71A is formed in the pattern shown in Fig. 27. Thereafter, the second structure body 70 can be obtained by forming the adhesion layer 75B on a second surface of the layer 75A. The adhesion layer 75B can be formed according to Embodiment 1.

After the second structure body 70 is fabricated in this way, as shown in Fig. 26, the second structure body 70 is stuck at a desired position of the first structure body 60 (the flexible substrate) fabricated according to the related art such that the adhesion layer 75B comes into contact with the outermost layer 61A (or 61B) of the first structure body 60.

### <Embodiment 6>

An electronic apparatus related to this embodiment is based on the electronic apparatus related to Embodiment 5 and the configuration of the second structure body 70 is partially different in the two. Specifically, a configuration in the opening 71B of the island-shaped conductor 71A is different in the two. Since other configurations are the same as those in the electronic apparatus related to Embodiment 5, description thereof will not be repeated here.

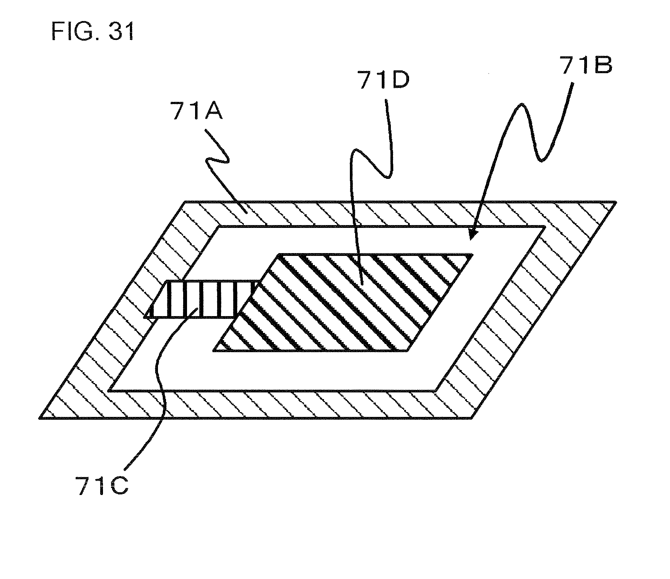

A cross-sectional view schematically showing the outermost layer 61 of the first structure body 60 and an example of the second structure body 70 in this embodiment is the same as that in Embodiment 5 (refer to Fig. 26). Next, an enlarged perspective view of the island-shaped conductor 71A of the second structure body 70 in this embodiment is shown in Fig. 31. In the second structure body 70 in this embodiment, the openings 71B as shown in Fig. 31 are provided at some or all of the plurality of island-shaped conductors 71A, and in some or all of the openings 71B, second island-shaped conductors 71D and the interconnections 71C are provided. The interconnection 71C electrically connects the island-shaped conductor 71A and the second island-shaped conductor 71D to each other.

Here, also in this embodiment as shown in Figs. 26 and 31, the EBG structure is constituted by the outermost layer 61 of the first structure body 60 and the second structure body 70. However, the EBG structure which is constituted in this embodiment is different from the EBG structures described in Embodiments 1 to 5.

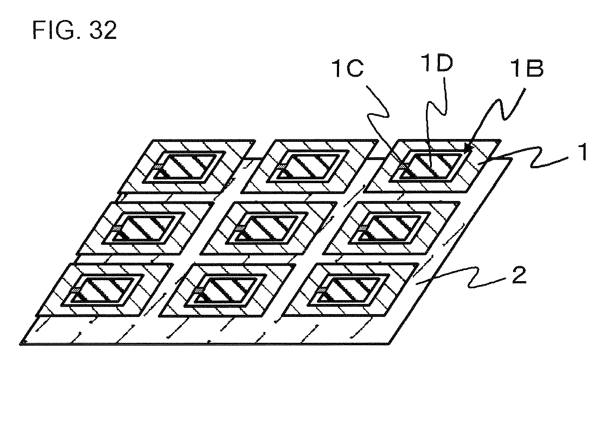

In Fig. 32, the EBG structure which is constituted by the outermost layer 61 of the first structure body 60 and the second structure body 70 in this embodiment is schematically shown. Fig. 32 is a perspective view schematically showing the configuration of the EBG structure. A cross-sectional view of this EBG structure is the same as that in Embodiment 5 (refer to Fig. 29).

The EBG structure shown in Figs. 29 and 32 is constituted by the sheet-shaped conductor 2, the plurality of island-shaped conductors 1 separated from each other, the openings 1B each provided at the island-shaped conductor 1, and the interconnections 1C and the second island-shaped conductors 1D provided in the openings 1B. The plurality of island-shaped conductors 1 is disposed at areas which overlap the sheet-shaped conductor 2 when seen in a plan view, and at positions away from the sheet-shaped conductor 2, with a dielectric layer (not shown in the drawings) interposed therebetween. Further, the plurality of island-shaped conductors 1 is arranged periodically. At the plurality of island-shaped conductors 1, the openings 1B are provided, and in each of the openings 1B, the interconnection 1C, one end of which is electrically connected to the island-shaped conductor 1, is provided. Further, in each of the openings 1B, the second island-shaped conductor 1D which is electrically connected to the other end of the interconnection 1C is provided.

In this EBG structure body, the unit cell A thereof is constituted by a single island-shaped conductor 1, the interconnection 1C and the second island-shaped conductor 1D provided in the opening 1B of the island-shaped conductor 1, and the area facing them of the sheet-shaped conductor 2. This unit cell A is periodically disposed, whereby this structure body functions as a metamaterial, for example, an EBG. In the example shown in Fig. 32, the unit cell A has a two-dimensional array when seen in a plan view.

A plurality of unit cells A has structures equal to as each other and is disposed in the same direction. The island-shaped conductor 1, the opening 1B, and the second island-shaped conductor 1D each have a square shape and are disposed such that the centers thereof overlap each other. The interconnection 1C extends approximately perpendicular to one side of the opening 1B from approximately the center of the side. Then, the interconnection 1C electrically connects the center of a first side of the second island-shaped conductor 1D and the center of a side facing the first side of the second island-shaped conductor 1D of the opening 1B to each other.

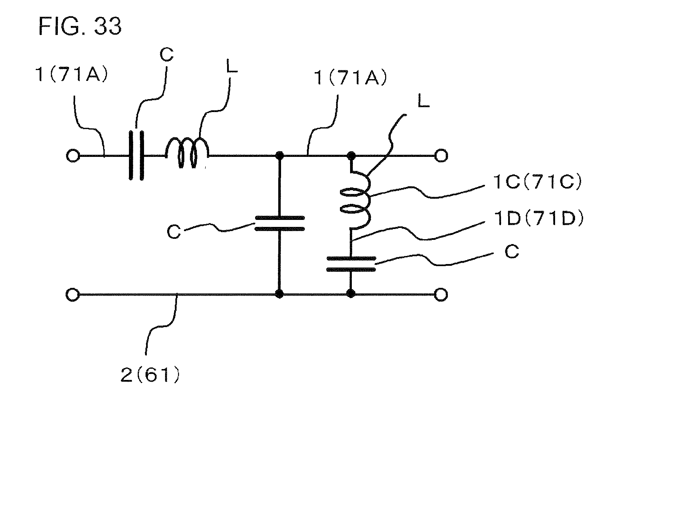

Fig. 33 is an equivalent circuit diagram of the unit cell A shown in Fig. 32. As shown in Fig. 33, a capacitor C is formed between the island-shaped conductor 1 and the sheet-shaped conductor 2. Further, a capacitor C is also formed between adjacent island-shaped conductors 1. Further, a capacitor C is also formed between the second island-shaped conductor 1D and the sheet-shaped conductor 2. Then, in the island-shaped conductor 1 having the opening 1B, an inductor L is formed. Further, the interconnection 1C which electrically connects the island-shaped conductors 1 and the second island-shaped conductor 1D to each other has an inductor L.

According to this EBG structure, propagation of noise in the surface of the sheet-shaped conductor 2 can be suppressed. Further, adjacent island-shaped conductors 1 form the capacitor C therebetween, whereby propagation of noise in the vicinity of the EBG structure body can be suppressed.

The connection body 40 in this embodiment in which the EBG structure as described above is constituted by the outermost layer 61 of the first structure body 60 and the second structure body 70 can suppress propagation of noise in the surface of the outermost layer 61 of the first structure body 60 at an area where the second structure body 70 is provided and can also suppress propagation of noise in the vicinity of the connection body 40.

According to the electronic apparatus related to this embodiment having such a connection body 40, by the EBG structure which is formed on the outer surface of the connection body 40, in addition to being able to suppress the movement of an electric current from the antenna 30 to the outer surface of the connection body 40, the movement of noise which is propagated through the outer surface of the connection body 40 (the outer surface of the first structure body 60), to the antenna 30, can be suppressed. That is, even in a case where the flexible substrate is disposed in the vicinity of the antenna, deterioration of antenna characteristics due to the flexible substrate can be suppressed.

Further, the flexible substrate (the connection body 40) is connected to an electronic circuit which is enclosed in the housing. However, in the case of using the structure in this embodiment, by preventing an unnecessary electric current from being generated in the flexible substrate (the connection body 40), the effect of preventing even the malfunctions or the like of other circuits is also obtained.

Further, in this embodiment, since the band-gap band of the EBG structure can be regulated, deterioration of the antenna characteristics can be effectively suppressed by regulating the band-gap band of the EBG structure in accordance with a frequency that the electronic apparatus uses. For example, the band-gap band of the EBG structure may also include some or all of frequency bands equal to or more than 700 MHz and equal to or less than 2.3 GHz. If it is in this numerical value range, it becomes possible to include a frequency band which is used in a mobile phone.

In addition, in this embodiment, two or more types of EBG structures different in band-gap band from each other are constituted by the second structure body 70 and the outermost layer 61 of the first structure body 60 and each of the EBG structures may also be disposed repeatedly, for example, periodically. If doing so, it becomes possible to broaden the band-gap band.

Since the second structure body 70 in this embodiment does not have the connecting members 73 unlike the second structure bodies 70 in Embodiments 1 to 4, the second structure body 70 in this embodiment need not be provided with means for securing conduction between the connecting members 73 and the outermost layer 61 of the first structure body 60. As a result, quality stability becomes high.

Since a method of manufacturing the electronic apparatus related to this embodiment can be realized according to the method of manufacturing the electronic apparatus described Embodiment 5, description thereof will not be repeated here.

### <Embodiment 7>

An electronic apparatus related to this embodiment is based on the electronic apparatus related to any one of Embodiments 1 to 6 and the configuration of the connection body 40 is different in the two. Since other configurations are the same as those in any one of Embodiments 1 to 6, description thereof will not be repeated here.

In Embodiments 1 to 6, the first structure body 60 is a flexible substrate having a multilayer structure, the second structure body 70 is a sheet having the adhesion layer 75B, and the connection body 40 is constituted by sticking the second structure body 70 in contact with the outermost layer 61 of the first structure body 60.

In contrast to this, in this embodiment, a flexible substrate having a multilayer structure, that is, the connection body 40 is constituted by the first structure body 60 and the second structure body 70.

A method of manufacturing the electronic apparatus related to this embodiment is not particularly limited and can be realized using a conventional layer formation technique. That is, the connection bodies 40 having the configurations described in Embodiments 1 to 6 can be manufactured, for example, by combining a chemical vapor deposition method (a CVD method), a chemical-mechanical polishing method (a CMP method), photolithography, etching, or the like.

According to the electronic apparatus related to this embodiment, in addition to the effects described in Embodiments 1 to 6, the effect of extending the life of the function of suppressing deterioration of antenna characteristics can be obtained.

That is, in the cases of Embodiments 1 to 6, there is a concern that the second structure body 70 (the sheet) may be peeled off from the first structure body 60 (the flexible substrate) due to the performance life of the adhesion layer 75B (the adhesive) of the second structure body 70 (the sheet) or an unexpected factor.

In contrast to this, in the case of this embodiment, since the adhesion between the first structure body 60 and the second structure body 70 is strong compared to those in Embodiments 1 to 6, a disadvantage as described above does not easily arise.

### <Embodiment 8>

An electronic apparatus related to this embodiment is based on the electronic apparatus related to any one of Embodiments 1 to 7 and the configuration of the second structure body 70 is partially different in the two. Since other configurations are the same as those in any one of Embodiments 1 to 7, description thereof will not be repeated here.

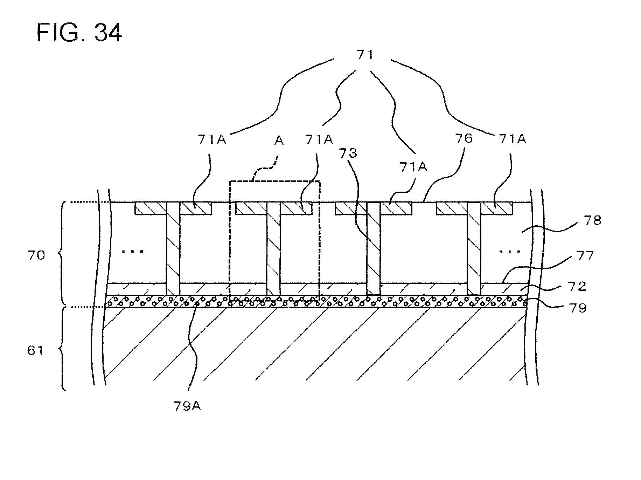

Fig. 34 is a cross-sectional view schematically showing the outermost layer 61 of the first structure body 60 and an example of the second structure body 70 in this embodiment. The second structure body 70 in this embodiment includes, for example, a first dielectric layer 78, a first conductor 71 which is formed to face a second conductor 72 over the surface 76 on one side of the first dielectric layer 78 and has a repeated structure, for example, a periodic structure at least in some areas, the second conductor 72 formed over the surface 77 (the surface on the opposite side to the surface 76) of the first dielectric layer 78, a second dielectric layer 79 formed over the second conductor 72, and a connecting member 73 which is provided in the inside of the first dielectric layer 78 and electrically connects the first conductor 71 and the second conductor 72 to each other. In addition, the first conductor 71 may also be provided to face the second conductor 72 in the inside of the first dielectric layer 78.

The configuration of the first conductor 71 shown in Fig. 34 is the same as that of the first conductor 71 described in, for example, Embodiment 1. Further, the configuration of the first dielectric layer 78 is the same as that of the dielectric layer 75 described in Embodiment 1 except that the first dielectric layer 78 does not have an adhesion layer.

The second conductor 72 is a sheet-shaped conductor extending over the surface 77 of the first dielectric layer 78 so as to face the plurality of island-shaped conductors 71A when seen in a plan view. The second conductor 72 can be formed of a material such as copper, for example.

The second dielectric layer 79 is provided over the surface (the surface on the opposite side to the surface which comes into contact with the first dielectric layer 78) of the second conductor 72 and comes into contact with the outermost layer 61 of the first structure body 60. That is, the second dielectric layer 79 is sandwiched between the outermost layer 61 of the first structure body 60 and the second conductor 72. The second dielectric layer 79 may also be an adhesion layer formed of natural rubber, acrylic resin, silicone, or the like. Or, the second dielectric layer 79 may also be a dielectric layer formed over the outermost layer 61 of the first structure body 60 by using, for example, a CVD method. In the inside of the second dielectric layer 79, a conduction member 79A is provided.

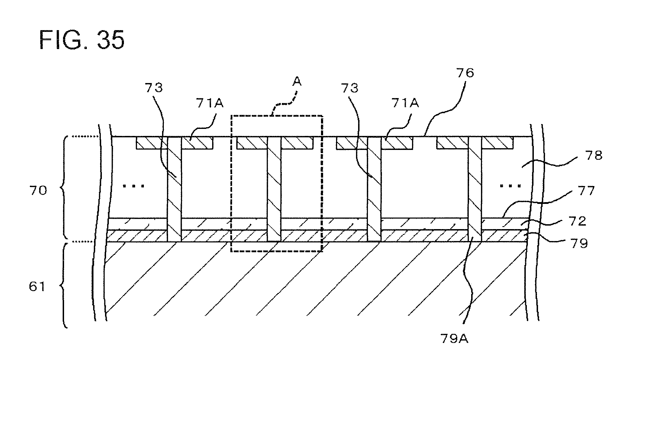

The conduction member 79A is constituted so as to allow conduction between the second conductor 72 and the outermost layer 61 of the first structure body 60. For example, the conduction member 79Amay also be a plurality of electrically conductive fillers mixed in the second dielectric layer 79. Alternatively, the conduction member 79A may also be a via as shown in Fig. 35.

Here, the configuration of the connecting member 73 in this embodiment is not limited to that shown in Fig. 34 and, for example, the configurations as shown in Figs. 15, 16, 20, 21, and 24 can be adopted. Since the connecting members 73 and the second structure bodies 70 shown in these drawings have been described in the above embodiments, description thereof will not be repeated here.

Further, in this embodiment, the connecting members 73 need not be provided. In such a case, at some or all of the plurality of island-shaped conductors 71A, the openings 71B and the interconnections 71C as shown in the enlarged perspective view of Fig. 27 are provided. Further, at some or all of the plurality of island-shaped conductors 71A, the openings 71B, the interconnections 71C, and the second island-shaped conductors 71D as shown in the enlarged perspective view of Fig. 31 may also be provided. Since the island-shaped conductors 71A and the second structure bodies 70 shown in these drawings have been described in the above embodiments, description thereof will not be repeated here.

A method of manufacturing the electronic apparatus related to this embodiment can be realized according to the above embodiments. Therefore, description thereof will not be repeated here.

In the electronic apparatus related to this embodiment, the second structure body 70 is provided with the EBG structure and is also provided with means for electrically connecting the EBG structure and the outermost layer 61 of the first structure body 60 to each other. According to the electronic apparatus related to this embodiment, the same effects as those in the above embodiments can be obtained.

### <Embodiment 9>

An electronic apparatus related to this embodiment is based on the electronic apparatus related to any one of Embodiments 1 to 7 and the configuration of the second structure body 70 is partially different in the two. Since other configurations are the same as those in any one of Embodiments 1 to 7, description thereof will not be repeated here.

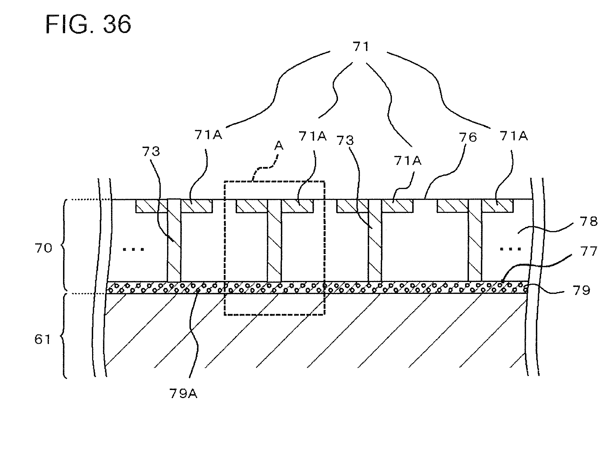

Fig. 36 is a cross-sectional view schematically showing the outermost layer 61 of the first structure body 60 and an example of the second structure body 70 in this embodiment. The second structure body 70 in this embodiment includes, for example, the first dielectric layer 78, the first conductor 71 which is formed to face the outermost layer 61 of the first structure body 60 over the surface 76 on one side of the first dielectric layer 78 and has a repeated structure, for example, a periodic structure at least in some areas, the second dielectric layer 79 formed over the surface 77 (the surface on the opposite side to the surface 76) of the first dielectric layer 78, and the connecting member 73 which is provided in the inside of the first dielectric layer 78 and electrically connects the first conductor 71 and the outermost layer 61 of the first structure body 60 to each other. In addition, the first conductor 71 may also be provided to face the outermost layer 61 of the first structure body 60 in the inside of the first dielectric layer 78.

The configuration of the first conductor 71 shown in Fig. 36 is the same as that of the first conductor 71 described in, for example, Embodiment 1. Further, the configuration of the first dielectric layer 78 is the same as that of the dielectric layer 75 described in Embodiment 1 except that the first dielectric layer 78 does not have an adhesion layer.

The second dielectric layer 79 is provided over the surface 77 of the first dielectric layer 78 and comes into contact with the outermost layer 61 of the first structure body 60. That is, the second dielectric layer 79 is sandwiched between the outermost layer 61 of the first structure body 60 and the first dielectric layer 78. The second dielectric layer 79 may also be an adhesion layer formed of natural rubber, acrylic resin, silicone, or the like. Or, the second dielectric layer 79 may also be a dielectric layer formed over the outermost layer 61 of the first structure body 60 by using, for example, a CVD method. In the inside of the second dielectric layer 79, the conduction member 79A is provided.

The conduction member 79A is constituted so as to allow conduction between the connecting member 73 exposed from the surface 77 of the first dielectric layer 78 and the outermost layer 61 of the first structure body 60. For example, the conduction member 79Amay also be a plurality of electrically conductive fillers mixed in the second dielectric layer 79.

Here, the configuration of the connecting member 73 in this embodiment is not limited to that shown in Fig. 36 and, for example, the configurations as shown in Figs. 15, 16, 20, 21, and 24 can be adopted. Since the connecting members 73 and the second structure bodies 70 shown in these drawings have been described in the above embodiments, description thereof will not be repeated here.

Further, in this embodiment, the connecting members 73 need not be provided. In such a case, at some or all of the plurality of island-shaped conductors 71A, the openings 71B and the interconnections 71C as shown in the enlarged perspective view of Fig. 27 are provided. Further, at some or all of the plurality of island-shaped conductors 71A, the openings 71B, the interconnections 71C, and the second island-shaped conductors 71D as shown in the enlarged perspective view of Fig. 31 may also be provided. Since the island-shaped conductors 71A and the second structure bodies 70 shown in these drawings have been described in the above embodiments, description thereof will not be repeated here.

A method of manufacturing the electronic apparatus related to this embodiment can be realized according to the above embodiments. Therefore, description thereof will not be repeated here.

In the electronic apparatus related to this embodiment, the EBG structure is constituted by the outermost layer 61 of the first structure body 60 and the second structure body 70. According to the electronic apparatus related to this embodiment, the same effects as those in the above embodiments can be obtained.

### <Embodiment 10>

An electronic apparatus related to this embodiment is based on the electronic apparatus related to Embodiment 1 and the configuration of the second structure body 70 is partially different in the two. Since other configurations are the same as those in the electronic apparatus related to Embodiment 1, description thereof will not be repeated here.

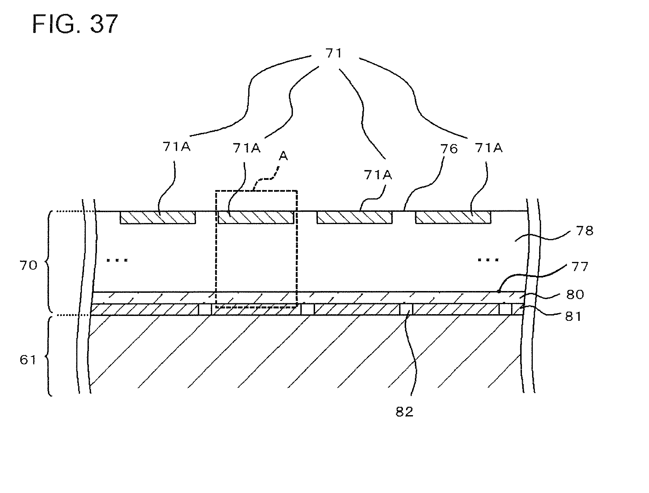

Fig. 37 is a cross-sectional view schematically showing the outermost layer 61 of the first structure body 60 and an example of the second structure body 70 in this embodiment. The second structure body 70 in this embodiment includes the first dielectric layer 78, the first conductor 71 which is formed to face a second conductor 80 over the surface 76 on one side of the first dielectric layer 78 and has a repeated structure, for example, a periodic structure at least in some areas, the second conductor 80 formed over the surface 77 (the surface on the opposite side to the surface 76) of the first dielectric layer 78, and a third dielectric layer 81 formed over the second conductor 80. In addition, the first conductor 71 may also be provided to face the second conductor 80 in the inside of the first dielectric layer 78.

The configuration of the first conductor 71 shown in Fig. 37 is the same as that of the first conductor 71 described in Embodiment 1 except that it is not connected to the connecting member 73. Further, the configuration of the first dielectric layer 78 is the same as that of the dielectric layer 75 described in Embodiment 1 except that the first dielectric layer 78 does not have an adhesion layer.

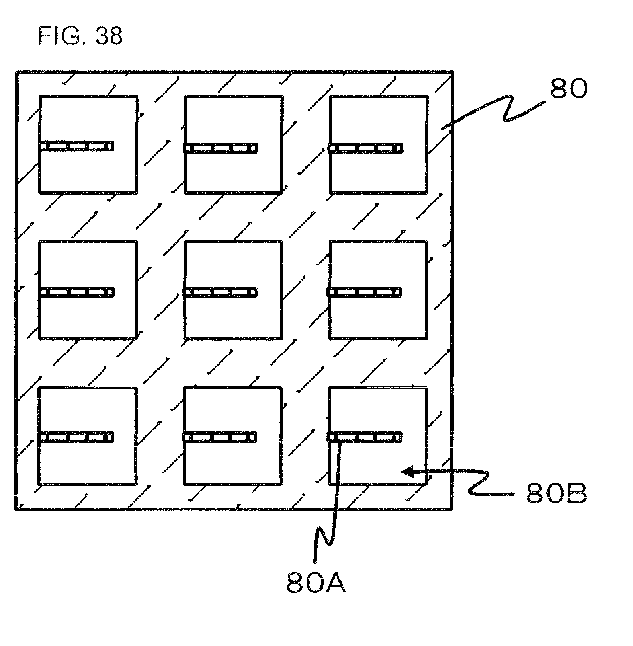

Here, in Fig. 38, an example of the planar shape of the second conductor 80 is schematically shown. The second conductor 80 has openings 80B. The openings 80B are respectively provided at positions facing the plurality of island-shaped conductors 71A which is arranged repeatedly. Further, in the opening 80B, an interconnection 80A, one end of which is electrically connected to the second conductor 80, is provided.

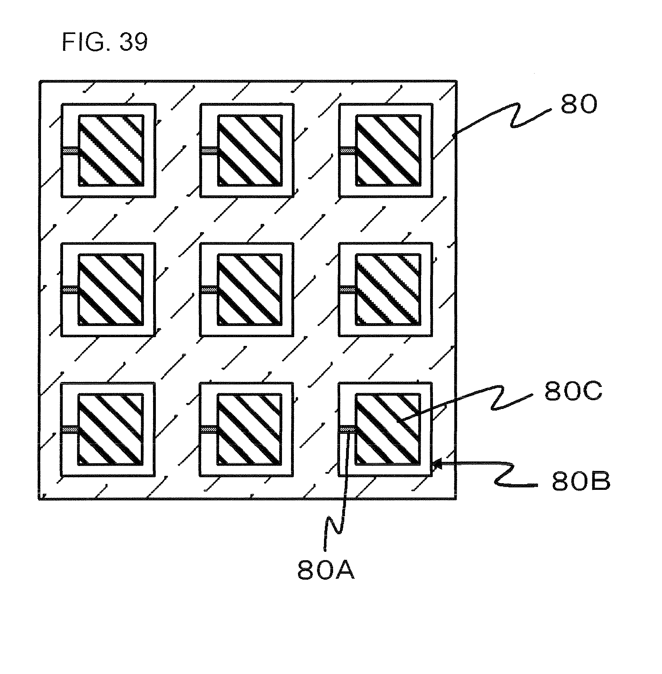

In Fig. 39, another example of the planar shape of the second conductor 80 is schematically shown. The second conductor 80 has the openings 80B. The openings 80B are respectively provided at positions facing the plurality of island-shaped conductors 71A which is arranged repeatedly. Further, in the opening 80B, the interconnection 80A and a second island-shaped conductor 80C are provided. In addition, the interconnection 80A electrically connects the second conductor 80 and the second island-shaped conductor 80C to each other.

The third dielectric layer 81 is provided over the surface (the surface on the opposite side to the surface which comes into contact with the first dielectric layer 78) of the second conductor 80 and comes into contact with the outermost layer 61 of the first structure body 60. That is, the third dielectric layer 81 is sandwiched between the outermost layer 61 of the first structure body 60 and the second conductor 80. The third dielectric layer 81 may also be an adhesion layer formed of natural rubber, acrylic resin, silicone, or the like. Or, the third dielectric layer 81 may also be a dielectric layer formed over the outermost layer 61 of the first structure body 60 by using, for example, a CVD method. In the third dielectric layer 81, a via 82 is provided.

The via 82 electrically connects the second conductor 80 and the outermost layer 61 of the first structure body 60 to each other. In addition, the shape of the second conductor 80 has the openings 80B, as described above, and has the interconnection 80A or the interconnection 80A and the second island-shaped conductor 80C in each opening 80B. However, it is preferable that the via 82 be electrically connected to the second conductor 80 rather than the interconnection 80A and the second island-shaped conductor 80C. If doing so, stable connection can be realized.

Here, in this embodiment, the second structure body 70 is provided with the EBG structure. However, the EBG structure which the second structure body 70 in this embodiment has is different from the EBG structures described in Embodiments 1 to 9.

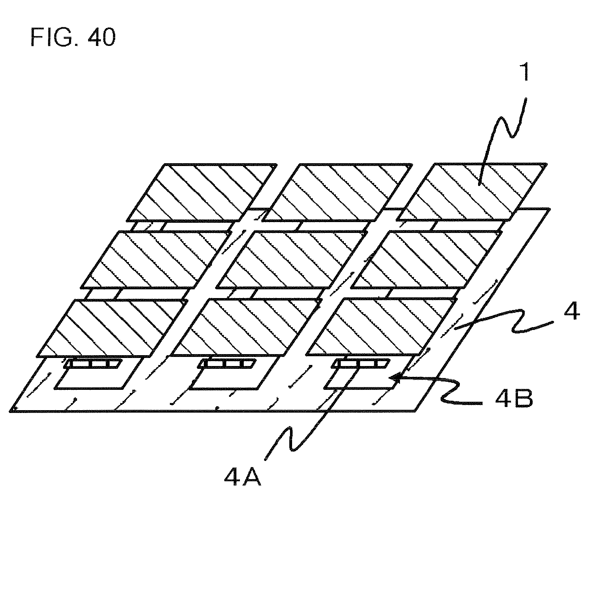

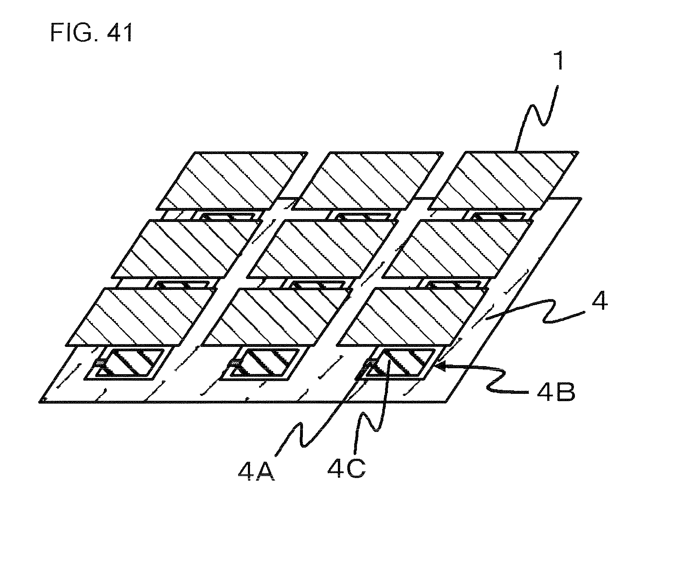

In Figs. 40 and 41, perspective views schematically showing the EBG structures each composed of the second conductor 80 as described above and the plurality of island-shaped conductors 71A are shown. An equivalent circuit diagram of the unit cell of the EBG structure shown in Fig. 40 is that in which in the equivalent circuit diagram (refer to Fig. 30) of the unit cell A shown in Figs. 28 and 29, the positions of the capacitor C and the inductor L are changed to appropriate positions. Further, an equivalent circuit diagram of the unit cell of the EBG structure shown in Fig. 41 is that in which in the equivalent circuit diagram (refer to Fig. 33) of the unit cell A shown in Fig. 32, the positions of the capacitor C and the inductor L are changed to appropriate positions. Therefore, description thereof will not be repeated here.

Further, a method of manufacturing the electronic apparatus related to this embodiment can be realized according to the above embodiments. Therefore, description thereof will not be repeated here.

According to the electronic apparatus related to this embodiment, by the EBG structure which is formed on the outer surface of the connection body 40, in addition to being able to suppress the movement of an electric current from the antenna 30 to the outer surface of the connection body 40, the movement of noise which is propagated through the outer surface of the connection body 40 (the outer surface of the first structure body 60), to the antenna 30, can be suppressed. That is, even in a case where the flexible substrate is disposed in the vicinity of the antenna, deterioration of antenna characteristics due to the flexible substrate can be suppressed.

Further, the flexible substrate (the connection body 40) is connected to an electronic circuit which is enclosed in the housing. However, in the case of using the structure in this embodiment, by preventing an unnecessary electric current from being generated in the flexible substrate (the connection body 40), the effect of preventing even the malfunctions or the like of other circuits is also obtained.

Further, in this embodiment, since the band-gap band of the EBG structure can be regulated, deterioration of the antenna characteristics can be effectively suppressed by regulating the band-gap band of the EBG structure in accordance with a frequency that the electronic apparatus uses. For example, the band-gap band of the EBG structure may also include some or all of frequency bands equal to or more than 700 MHz and equal to or less than 2.3 GHz. If it is in this numerical value range, it becomes possible to include a frequency band which is used in a mobile phone.

In addition, in this embodiment, the EBG structures which the second structure body 70 has are two or more types of EBG structures different in band-gap band from each other and each of the EBG structures may also be disposed repeatedly, for example, periodically. If doing so, it becomes possible to broaden the band-gap band.

Since the second structure body 70 in this embodiment does not have the connecting members 73 unlike the second structure bodies 70 in Embodiments 1 to 4, the second structure body 70 in this embodiment need not be provided with means for securing conduction between the connecting members 73 and the outermost layer 61 of the first structure body 60. As a result, quality stability becomes high.

### <Embodiment 11>

An electronic apparatus related to this embodiment is based on the electronic apparatus related to Embodiment 10 and means for constituting the EBG structures as shown in Figs. 40 and 41 is different in the two. Since other configurations are the same as those in the electronic apparatus related to Embodiment 1, description thereof will not be repeated here.

In this embodiment, the outermost layer 61 of the first structure body 60 constitutes a second conductor 4 of each of the EBG structures shown in Figs. 40 and 41. Means for forming the pattern of the second conductor 4 shown in Figs. 40 and 41 in the outermost layer 61 of the first structure body 60 is not particularly limited and, for example, it may also be formed by photolithography and etching. Further, in a case where the outermost layer 61 is formed of silver paste, it can be realized by applying silver paste through a mask with a predetermined pattern formed therein.

The second structure body 70 in this embodiment includes a dielectric layer which comes into contact with the outermost layer 61 of the first structure body 60, and a first conductor which is provided over the surface (the surface on the opposite side to the surface which comes into contact with the outermost layer 61 of the first structure body 60) of the dielectric layer or in the inside of the dielectric layer. The first conductor faces the outermost layer 61 of the first structure body 60 and has a repeated structure, for example, a periodic structure at least in some areas. As the repeated structure, as shown in Figs. 40 and 41, a structure is conceivable in which the plurality of island-shaped conductors 1 separated from each other is provided repeatedly, for example, periodically.

Means for providing the second structure body 70 in contact with the outermost layer 61 of the first structure 60 in this embodiment is not particularly limited and any means described in the above embodiments can be used.

According to the electronic apparatus related to this embodiment, by the EBG structure which is formed on the outer surface of the connection body 40, in addition to being able to suppress the movement of an electric current from the antenna 30 to the outer surface of the connection body 40, the movement of noise which is propagated through the outer surface of the connection body 40 (the outer surface of the first structure body 60), to the antenna 30, can be suppressed. That is, even in a case where the flexible substrate is disposed in the vicinity of the antenna, deterioration of antenna characteristics due to the flexible substrate can be suppressed.

Further, the flexible substrate (the connection body 40) is connected to an electronic circuit which is enclosed in the housing. However, in the case of using the structure in this embodiment, by preventing an unnecessary electric current from being generated in the flexible substrate (the connection body 40), the effect of preventing even the malfunctions or the like of other circuits is also obtained.

Further, in this embodiment, since the band-gap band of the EBG structure can be regulated, deterioration of the antenna characteristics can be effectively suppressed by regulating the band-gap band of the EBG structure in accordance with a frequency that the electronic apparatus uses. For example, the band-gap band of the EBG structure may also include some or all of frequency bands equal to or more than 700 MHz and equal to or less than 2.3 GHz. If it is in this numerical value range, it becomes possible to include a frequency band which is used in a mobile phone.

In addition, in this embodiment, two or more types of EBG structures different in band-gap band from each other are constituted by the second structure body 70 and the outermost layer 61 of the first structure body 60 and each of the EBG structures may also be disposed repeatedly, for example, periodically. If doing so, it becomes possible to broaden the band-gap band.

Since the second structure body 70 in this embodiment does not have the connecting members 73 unlike the second structure bodies 70 in Embodiments 1 to 4, the second structure body 70 in this embodiment need not be provided with means for securing conduction between the connecting members 73 and the outermost layer 61 of the first structure body 60. As a result, quality stability becomes high.

This application claims the right of priority based on Japanese Patent Application No. 2010-064759 filed on March 19, 2010, the entire contents of which are incorporated herein by reference.

## Claims

1. An electronic apparatus comprising:
a first housing which is provided with a first electronic component;
a second housing which is provided with a second electronic component;
an antenna which is provided at an end portion of the first housing; and
a connection body which passes through the end portion of the first housing and connects the first electronic component and the second electronic component to each other,
wherein the connection body has an electric conductor layer, a dielectric layer, and a first conductor having a repeated structure at least in some areas.

2. The electronic apparatus according to Claim 1, wherein the connection body includes
a first structure body which has a laminated structure that includes an electric conductor and a dielectric, and outermost layers of which become electric conductor layers, and
a second structure body which is provided in contact with an outer surface of at least one of the outermost layers of the first structure body, and
the second structure body includes
a dielectric layer which comes into contact with a first outermost layer of the first structure body, and
the first conductor which is provided to face the first outermost layer in the inside of the dielectric layer or over the surface on the opposite side to a surface which comes into contact with the first outermost layer, and has a repeated structure at least in some areas.

3. The electronic apparatus according to Claim 2, wherein the repeated structure of the first conductor is a plurality of island-shaped conductors separated from each other, and
further has a connecting member which is provided in the inside of the dielectric layer and connects at least some of the island-shaped conductors and the first outermost layer of the first structure body to each other.

4. The electronic apparatus according to Claim 2, wherein the repeated structure of the first conductor is a plurality of island-shaped conductors separated from each other,
an opening is provided in at least some of the island-shaped conductors, and
an interconnection which is connected to the island-shaped conductor is provided in the opening.

5. The electronic apparatus according to any one of Claims 2 to 4, wherein the first structure body is a flexible substrate having a multilayer structure, and
the second structure body is a sheet in which at least a portion of the dielectric layer constitutes an adhesion layer which adheres to the outermost layer of the first structure body.

6. The electronic apparatus according to any one of Claims 2 to 4, wherein a flexible substrate having a multilayer structure is constituted by the first structure body and the second structure body.

7. The electronic apparatus according to Claim 1, wherein the connection body includes
a first structure body which has a laminated structure that includes an electric conductor and a dielectric, and outermost layers of which become electric conductor layers, and
a second structure body which is provided in contact with an outer surface of at least one of the outermost layers of the first structure body, and
the second structure body includes
a first dielectric layer,
the first conductor which is provided in the inside or over a first surface of the first dielectric layer and has a repeated structure at least in some areas,
a second conductor which is provided to face the first conductor over the surface on the opposite side to the first surface of the first dielectric layer,
a second dielectric layer which is provided over the second conductor and comes into contact with the outermost layer of the first structure body, and
a conduction member which is provided in the inside of the second dielectric layer and allows conduction between the second conductor and the outermost layer of the first structure body.

8. The electronic apparatus according to Claim 7, wherein the repeated structure of the first conductor is a plurality of island-shaped conductors separated from each other, and
further has a connecting member which is provided in the inside of the first dielectric layer and connects at least some of the island-shaped conductors and the second conductor to each other.

9. The electronic apparatus according to Claim 7, wherein the repeated structure of the first conductor is a plurality of island-shaped conductors separated from each other,
an opening is provided in at least some of the island-shaped conductors, and
an interconnection which is connected to the island-shaped conductor is provided in the opening.

10. The electronic apparatus according to any one of Claims 7 to 9, wherein the conduction member is a via or an electrically conductive filler.

11. The electronic apparatus according to any one of Claims 7 to 10, wherein the first structure body is a flexible substrate having a multilayer structure, and
the second structure body is a sheet in which the second dielectric layer constitutes an adhesion layer which adheres to the outermost layer of the first structure body.

12. The electronic apparatus according to any one of Claims 7 to 10, wherein a flexible substrate having a multilayer structure is constituted by the first structure body and the second structure body.

13. The electronic apparatus according to any one of Claims 1 to 12, wherein the second structure body is provided at least at a place closest to a feeding point of the antenna in the outer surface of the outermost layer of the first structure body.

14. The electronic apparatus according to any one of Claims 1 to 13, wherein the antenna and the connection body have superimposed areas which overlap each other when the electronic apparatus is seen in a plan view, and
the second structure body is provided at least at the superimposed area in the outer surface of the outermost layer of the first structure body.

15. The electronic apparatus according to any one of Claims 1 to 14, further comprising:
a hinge which connects the first housing and the second housing to each other,
wherein the antenna has an area which overlaps the hinge when the electronic apparatus is seen in a plan view, and
the connection body passes through the inside of the hinge.

16. The electronic apparatus according to any one of Claims 1 to 6, wherein an EBG structure body having one or more types of EBG structures is constituted by the first outermost layer of the first structure body and the second structure body which comes into contact with the first outermost layer.

17. The electronic apparatus according to any one of Claims 7 to 12, wherein the second structure body constitutes an EBG structure body having one or more types of EBG structures.

18. The electronic apparatus according to Claim 16 or 17, wherein the EBG structure includes at least some of frequency bands equal to or more than 700 MHz and equal to or less than 2.3 GHz in a band-gap band.
